# EUROPEAN PATENT APPLICATION

(11) **EP 2 940 781 A1**
(43) Date of publication of application: **04.11.2015**
(21) Application number: 13867495.7
(22) Date of filing: 18.12.2013
(51) Int. Cl.: H01M 14/00, C09B 23/00, C09B 57/10, C09B 67/02, H01L 31/04

(54) **LOADED BODY AND PHOTOELECTRIC CONVERSION ELEMENT**

(30) Priority: 28.12.2012 JP 2012286923; 29.08.2013 JP 2013177767
(71) Applicant: Adeka Corporation, Tokyo 116-8554 (JP)
(72) Inventor: OSADA, Hiroyuki, Tokyo 116-8554 (JP); AKIMOTO, Kensaku, Tokyo 116-8554 (JP); AOYAMA, Yohei, Tokyo 116-8554 (JP); NODA, Kazuyuki, Tokyo 116-8554 (JP); YANO, Toru, Tokyo 116-8554 (JP); TANIUCHI, Ryo, Tokyo 116-8554 (JP); KAKIAGE, Kenji, Tokyo 116-8554 (JP)
(74) Representative: Forstmeyer, Dietmar
(86) International application number: PCT/JP2013/083891
(87) International publication number: WO 2014/103831

(57) **Abstract**

This carrier system carries at least one type of sensitizing dye described in (A) below and at least one type of sensitizing dye described in (B) below: (A) a sensitizing dye having a π-conjugated group and at least one anchor group, wherein the π-conjugated group and every one of the anchor group(s) are connected by a spacer having at least one alkylene and having an atomicity of 5 to 20; and (B) a sensitizing dye having a π-conjugated group and at least one anchor group, wherein the π-conjugated group and at least one anchor group are connected by a direct bond or by a spacer having at least one alkylene and having an atomicity of 1 to 4. In (A) and (B), the spacer is composed of carbon atoms, or carbon atoms and oxygen atom(s) etc., under predetermined conditions (see Description), and may have a branched chain or a ring structure.

## Description

### TECHNICAL FIELD

The present invention relates to a carrier system, a photoelectric conversion device provided with an electrode including the carrier system, and a novel compound.

### BACKGROUND ART

Dyes are widely used in a variety of technical fields. In the field of photoelectric conversion devices such as solar cells, for instance, dyes having photosensitizing properties have been used in dye-sensitized photoelectric conversion devices. Dye-sensitized photoelectric conversion devices are expected to theoretically achieve high efficiency and be produced at lower cost than conventional photoelectric conversion devices employing silicon semiconductors. Unfortunately, dye-sensitized photoelectric conversion devices suffer in that the utilization efficiency of light is low and the devices' photoelectric conversion efficiency is low because the absorption wavelengths of sensitizing dyes are limited compared to that of silicon.

Methods for solving the aforementioned problem have been considered, such as (1) a method of shifting and widening the absorption wavelength range of the sensitizing dye toward the long-wavelength side (Non-Patent Literature 1), and (2) a method of using, in combination, sensitizing dyes having different absorption wavelength ranges (Patent Literature 1 and 2). Unfortunately, with Method (1), it is difficult to shift the dye's absorption wavelength range to substantially the same range of conventional silicon semiconductors, and with Method (2), it is difficult to allow a plurality of sensitizing dyes to be carried efficiently, and there are unresolved issues such as that dye-carrying stability is low and photoelectric conversion efficiency is not improved, even though the absorption wavelength range may be widened.

### CITATION LIST

### PATENT LITERATURE

Patent Literature 1: JP 2008-034258A
Patent Literature 2: JP 2009-212035A

### NON-PATENT LITERATURE

Non-Patent Literature 1: Chem. Commun., pp. 1705-1706, 1997.

### SUMMARY OF INVENTION

### TECHNICAL PROBLEM

An objective of the present invention is to provide a carrier system that is used in dye-sensitized solar cells, has a widened absorption wavelength range, and has high photoelectric conversion efficiency and high durability. Another objective of the present invention is to provide a combination of sensitizing dyes that solves the aforementioned problem, and a method for producing a carrier system by using those sensitizing dyes. Another objective of the present invention is to provide a novel sensitizing dye for solving the aforementioned problem.

### SOLUTION TO PROBLEM

As a result of extensive studies, the present inventors have found that the aforementioned objective can be achieved by combining specific sensitizing dyes. The present invention has been completed based on these findings.

The present invention provides a carrier system carrying at least one type of sensitizing dye described in (A) below and at least one type of sensitizing dye described in (B) below:
(A) a sensitizing dye having a π-conjugated group and at least one anchor group, wherein: the π-conjugated group and every one of the anchor group(s) are connected by a spacer having at least one alkylene and having an atomicity of 5 to 20; the spacer is composed of carbon atoms, or at least one carbon atom and at least one type of atom selected from an oxygen atom, a nitrogen atom, a phosphorus atom, a silicon atom, and a sulfur atom, on condition that there are less than three consecutive nitrogen atoms and that atoms of the same type, other than carbon atoms and nitrogen atoms, do not adjoin one another; and the spacer may have a branched chain or a ring structure; and
(B) a sensitizing dye having a π-conjugated group and at least one anchor group, wherein: the π-conjugated group and at least one anchor group are connected by a direct bond or by a spacer having at least one alkylene and having an atomicity of 1 to 4; the spacer is composed of at least one carbon atom, or at least one carbon atom and at least one type of atom selected from an oxygen atom, a nitrogen atom, a phosphorus atom, a silicon atom, and a sulfur atom, on condition that atoms of the same type, other than carbon atoms, do not adjoin one another; and the spacer may have a branched chain or a ring structure.

The present invention also provides a photoelectric conversion device provided with an electrode including the aforementioned carrier system.

The present invention also provides a production method of the aforementioned carrier system.

The present invention also provides a compound comprising a π-conjugated group and at least one anchor group, wherein:
the π-conjugated group is represented by a partial structural formula (1') shown below;
the π-conjugated group and every one of the anchor group(s) are connected by a spacer having at least one alkylene and having an atomicity of 5 to 20;
the spacer is composed of carbon atoms, or at least one carbon atom and at least one type of atom selected from an oxygen atom, a nitrogen atom, a phosphorus atom, and a sulfur atom, on condition that atoms of the same type, other than carbon atoms, do not adjoin one another; and
the spacer may have a branched chain or a ring structure; 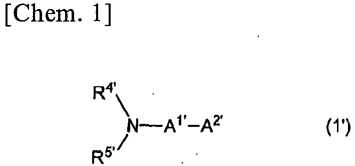
(in the formula, A¹' is an aromatic hydrocarbon ring group that may be substituted or an aromatic hetero ring group that may be substituted, A²' is a direct bond or a group obtained by connecting one to nine groups selected from groups represented by formulas (A2'-1) to (A2'-19) shown below, R⁴' and R⁵' each represent a hydrogen atom or a hydrocarbon group that may be substituted, R⁴' and R⁵' may be connected together to form a ring, and R⁴' and R⁵' may each independently connect with A¹' to form a ring); 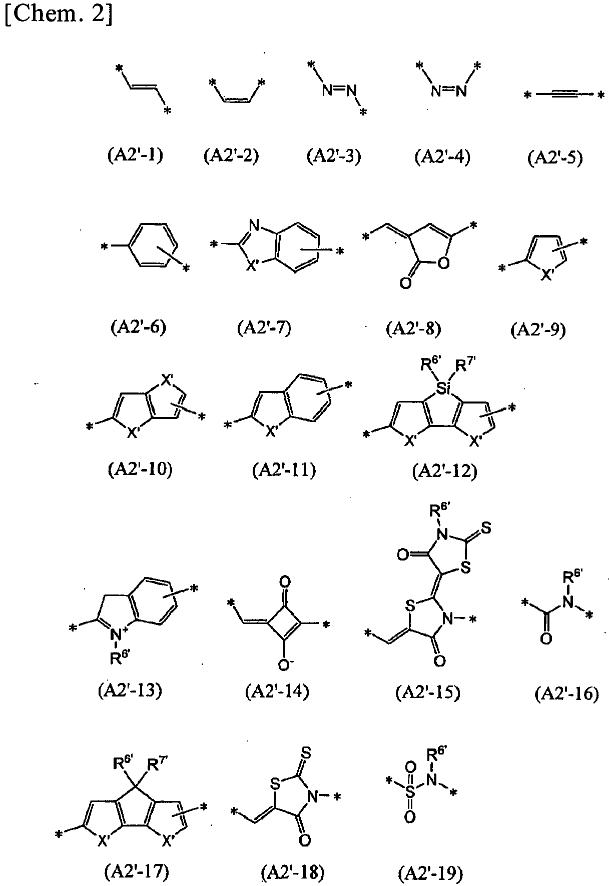 (in the formula, X' represents S, O, or NR', R' represents a hydrogen atom or a hydrocarbon group that may be substituted, a hydrogen atom in this group may be substituted by a fluorine atom, a chlorine atom, a bromine atom, an iodine atom, a cyano group, a nitro group, an -OR⁶' group, an -SR⁶' group, an -NR⁶'R⁷', group, or an aliphatic hydrocarbon group that may be substituted, and R⁶' and R⁷' each represent a hydrogen atom or a hydrocarbon group that may be substituted).

### EFFECTS OF INVENTION

The carrier system of the present invention has a wide absorption wavelength range, exhibits excellent photoelectric conversion efficiency, provides a highly durable carrier system and electrode, and is suitable for photoelectric conversion devices such as solar cells. Further, the carrier system of the present invention can be produced with a small number of processes, and can produce a photoelectric conversion device at lower cost than conventional art.

### BRIEF DESCRIPTION OF DRAWINGS

[Fig. 1] Fig. 1 schematically illustrates a cross-sectional structure of an example of a photoelectric conversion device according to the invention.
[Fig. 2] Fig. 2 is an enlarged view of an essential part of the photoelectric conversion device of the invention illustrated in Fig. 1.

### DESCRIPTION OF EMBODIMENTS

A carrier system of the present invention, a photoelectric conversion device using the carrier system, a method for producing the carrier system, and a novel compound used for the carrier system of the present invention are described below according to preferred embodiments thereof.

First, the carrier system according to the invention will be described.

Examples of materials (carriers) used in the carrier system of the present invention include: organic resins, such as acrylic resins and fluororesins; metal oxides, such as titanium oxide, zinc oxide, and aluminum oxide; silicon oxide, zeolite, and activated carbon. Preferred are those having a porous surface. The compounds to be carried are characterized by including at least one type of each of sensitizing dyes respectively having the aforementioned characteristics (A) and (B). The compounds each include an anchor group, and are thus adsorbed onto the carrier.

The form of the carrier is not particularly limited and may be chosen from, for example, thin film, powder, and granules as appropriate to the use of the carrier system. The size of the carrier and the amount of the sensitizing dyes (A) and (B) to be carried in the carrier system of the present invention are not particularly limited and may be chosen as appropriate to the use of the carrier system.

The π-conjugated group in the sensitizing dye described in (A) above refers to a group that includes consecutively-formed unsaturated bonds and lone pair(s) and that can assume a series of resonance structures.

A hydrogen atom in the π-conjugated group may be substituted by a fluorine atom, a chlorine atom, an iodine atom, a cyano group, a nitro group, an -OR⁴ group, an -SR⁴ group, an -NR⁴R⁵ group, or an aliphatic hydrocarbon group that may be substituted by a fluorine atom, a chlorine atom, an iodine atom, a cyano group, a nitro group, an -OR⁴ group, an -SR⁴ group, or an -NR⁴R⁵ group. R⁴ and R⁵ each represent a hydrogen atom or a hydrocarbon group that may be substituted. The group represented by R⁴ or R⁵ group may be a group having a spacer and an anchor group.

It is preferable if the sensitizing dye (A) includes a nitrogen atom in the π-conjugated group and/or the group substituting the π-conjugated group is substituted by -NR⁴R⁵ because the later-described photoelectric conversion efficiency is improved. Among π-conjugated groups, it is preferable that the carbon number in the consecutively-formed unsaturated bonds is from 4 to 60, more preferably from 4 to 40.

Examples of the hydrocarbon group that may be substituted as represented by R⁴ and R⁵ include aromatic hydrocarbon groups, aromatic hydrocarbon groups substituted by an aliphatic hydrocarbon, and aliphatic hydrocarbon groups.

Examples of the aromatic hydrocarbon groups include phenyl, naphthyl, cyclohexyl phenyl, biphenyl, terphenyl, fluorenyl, thiophenylphenyl, furanylphenyl, 2'-phenyl-propylphenyl, benzyl, and naphthylmethyl.

As for the aliphatic hydrocarbon groups, examples of C₁₋₂₀ aliphatic hydrocarbon groups include linear, branched, and cyclic alkyl groups such as methyl, ethyl, propyl, isopropyl, butyl, s-butyl, t-butyl, isobutyl, amyl, isoamyl, t-amyl, hexyl, heptyl, isoheptyl, t-heptyl, n-octyl, isooctyl, t-octyl, nonyl, cyclopropyl, cyclobutyl, cyclopentyl, cyclohexyl, cycloheptyl, cyclooctyl, cyclononyl, and cyclodecyl. The C₁₋₂₀ aliphatic hydrocarbon group may be interrupted by -O-, -COO-, -OCO-, -CO-, -S-, -SO-, -SO₂-, -NR¹⁵-, -C=C-, or -C≡C-, wherein R¹⁵ is a C₁₋₂₀ aliphatic hydrocarbon group, examples thereof including the same examples as the aforementioned C₁₋₂₀ aliphatic hydrocarbon group. If the interrupting group includes a carbon atom, the carbon number of the aliphatic hydrocarbon group, including the carbon in the interrupting group, is from 1 to 20.

Examples of the aromatic hydrocarbon groups substituted by an aliphatic hydrocarbon group include phenyl, naphthyl, benzyl, etc., substituted by the aforementioned aliphatic hydrocarbon group.

Examples of groups that may substitute the aforementioned hydrocarbon groups include a fluorine atom, a chlorine atom, a bromine atom, an iodine atom, a cyano group, a nitro group, a hydroxyl group, a thiol group, and an -NR⁴R⁵ group.

Preferred among sensitizing dyes described in (A) are sensitizing dyes in which the π-conjugated group is represented by the partial structural formula (1) shown below. In this case, the position where the spacer is bonded is, for example, at the nitrogen atom (in cases where R⁴ or R⁵ includes a spacer) and/or at A² in the partial structural formula (1) shown below. 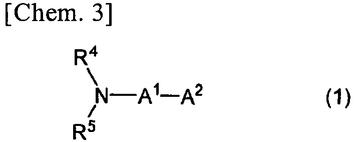 (in the formula, A¹ is an aromatic hydrocarbon ring group that may be substituted or an aromatic hetero ring group that may be substituted, A² is a direct bond or a group obtained by connecting one to nine groups selected from groups represented by formulas (A2-1) to (A2-19) shown below, R⁴ and R⁵ each represent a hydrogen atom or a hydrocarbon group that may be substituted, R⁴ and R⁵ may be connected together to form a ring, and R⁴ and R⁵ may each independently connect with A¹ to form a ring); 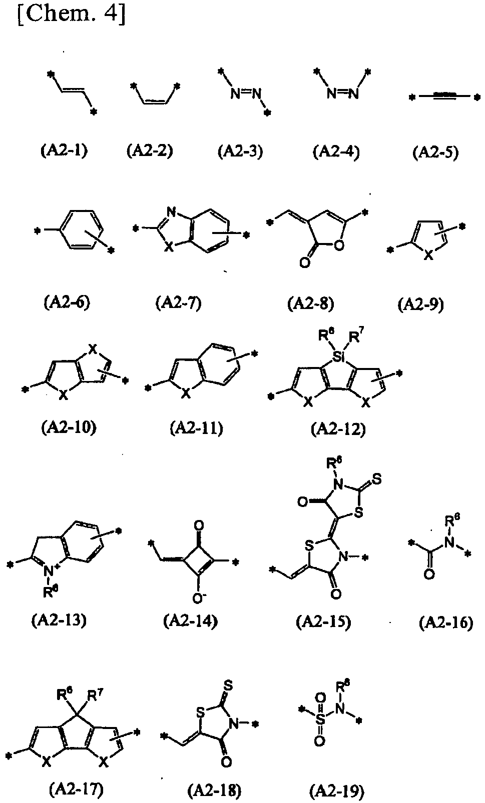 (in the formula, X represents S, O, or NR, R represents a hydrogen atom or a hydrocarbon group that may be substituted, a hydrogen atom in this group may be substituted by a fluorine atom, a chlorine atom, a bromine atom, an iodine atom, a cyano group, a nitro group, an -OR⁶ group, an -SR⁶ group, an -NR⁶R⁷ group, or an aliphatic hydrocarbon group that may be substituted, and R⁶ and R⁷ each represent a hydrogen atom or a hydrocarbon group that may be substituted).

The group represented by A¹ in the aforementioned partial structural formula (1) is a divalent group, and is an aromatic hydrocarbon ring group that may be substituted or an aromatic hetero ring group that may be substituted.

Examples of the aromatic hydrocarbon ring group include non-substituted aromatic hydrocarbon ring groups, and aromatic hydrocarbon ring groups substituted by an aliphatic hydrocarbon group. Examples of the aromatic hetero ring group include non-substituted aromatic hetero ring groups, and aromatic hetero ring groups substituted by an aliphatic hydrocarbon group.

Examples of the divalent non-substituted aromatic hydrocarbon ring group include 1,2-phenylene, 1,3-phenylene, 1,4-phenylene, naphthalene-1,2-diyl, naphthalene-1,3-diyl, naphthalene-1,4-diyl, naphthalene-1,5-diyl, naphthalene-1,6-diyl, naphthalene-1,7-diyl, naphthalene-1,8-diyl, naphthalene-2,3-diyl, naphthalene-2,6-diyl, anthracene-1,4-diyl, anthracene-1,5-diyl, anthracene-1,10-diyl, anthracene-9,10-diyl, perylene-3,10-diyl, pyrene-1,6-diyl, and pyrene-2,7-diyl.

Examples of the divalent aromatic hydrocarbon ring group substituted by an aliphatic hydrocarbon group include groups in which the aforementioned divalent non-substituted aromatic hydrocarbon ring is substituted at one to three sites by a C₁₋₂₀ aliphatic hydrocarbon group.

Examples of the C₁₋₂₀ aliphatic hydrocarbon group include the same groups exemplified in the description of aforementioned R⁴.

Examples of the divalent non-substituted aromatic hetero ring group include furan-2,5-diyl, furan-3,5-diyl, thiophene-2,5-diyl, thiophene-3,5-diyl, 2H-chromene-3,7-diyl, benzothiophene-2,6-diyl, and benzothiophene-2,5-diyl.

Examples of the divalent aromatic hetero ring group substituted by an aliphatic hydrocarbon group include 1-alkyl-pyrrole-2,5-diyl, 1-alkyl-pyrrole-3,5-diyl, and groups in which the aforementioned divalent non-substituted aromatic hetero ring group is substituted at one to three sites by a C₁₋₂₀ aliphatic hydrocarbon group. Examples of the C₁₋₂₀ aliphatic hydrocarbon group include the same groups as described above.

The aforementioned aromatic hydrocarbon ring group and aromatic hetero ring group may further be substituted, and examples of groups that may substitute the aromatic hydrocarbon ring group and the aromatic hetero ring group include a fluorine atom, a chlorine atom, a bromine atom, an iodine atom, a cyano group, a nitro group, a hydroxyl group, a thiol group, and an -NR⁶R⁷ group. R⁶ and R⁷ respectively represent the same groups as R⁶ and R⁷ in the aforementioned formulas (A2-1) to (A2-19). In cases where the aromatic hydrocarbon ring group or the aromatic hetero ring group includes methylene, the two hydrogen atoms may be substituted by an oxygen atom and form a carbonyl.

A² in the aforementioned partial structural formula (1) is a direct bond or a group obtained by connecting one to nine groups, preferably one to seven groups, more preferably two to four groups, selected from groups represented by the aforementioned formulas (A2-1) to (A2-19). In cases of connecting two or more of the aforementioned groups, the connected groups may be the same or different from one another. The direction for connecting each of the groups represented by the aforementioned formulas (A2-1) to (A2-19) is discretionary. It should be noted that the asterisk (*) in each of the aforementioned formulas (A2-1) to (A2-19) means that each group represented by the formula bonds with an adjacent group at the * part (the same applies hereinafter). The * part at the terminal of the group obtained by connecting one to nine groups is a hydrogen atom or an anchor group accompanied by a spacer with an atomicity of 5 to 20.

In the aforementioned formulas (A2-1) to (A2-19), X represents S, O, or NR, and R represents a hydrogen atom or a hydrocarbon group that may be substituted. Examples of the hydrocarbon group that may be substituted as represented by R are the same as those exemplified above for the hydrocarbon group that may be substituted as represented by R⁴.

A hydrogen atom in the groups represented by the aforementioned formulas (A2-1) to (A2-19) may be substituted by a fluorine atom, a chlorine atom, a bromine atom, an iodine atom, a cyano group, a nitro group, an -OR⁶ group, an -SR⁶ group, an -NR⁶R⁷ group, or an aliphatic hydrocarbon group that may be substituted, wherein R⁶ and R⁷ each represent a hydrogen atom or a hydrocarbon group that may be substituted. The groups substituting A² may be connected together to form a ring.

Examples of the aliphatic hydrocarbon group that may be substituted include the aforementioned C₁₋₂₀ aliphatic hydrocarbon groups, and examples of substituents that may substitute the group include those exemplified above as groups that may substitute the aforementioned aromatic hydrocarbon ring group and aromatic hetero ring group.

Examples of the hydrocarbon group that may be substituted as represented by R⁶ and R⁷ include those exemplified above as the hydrocarbon group that may be substituted as represented by R⁴. Examples of groups that may substitute the hydrocarbon group represented by R⁶ and R⁷ include those exemplified above as groups that may substitute the hydrocarbon group represented by R⁴.

Concrete examples of the structure of the A¹-A² part in the aforementioned partial structural formula (1) include A(1) to A(32) shown below. In the A part shown below, the ring structure on the left end is A¹, and the rest corresponds to A².

It should be noted that, although the following partials structures do not include substituents, A¹ may include a substituent, and a hydrogen atom in A² may be substituted by a substituent, as described above. In the following A(16) to A(23), the bonding hand illustrated so as to extend over a plurality of rings means that one of the carbon atoms constituting those rings forms a bond (the same applies hereinafter).

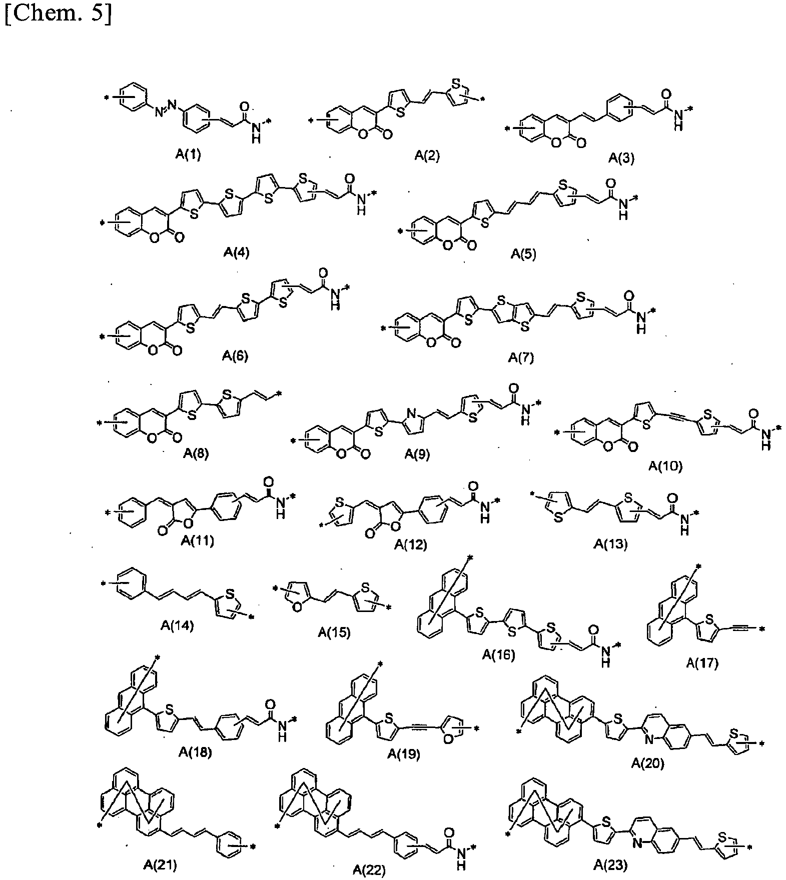

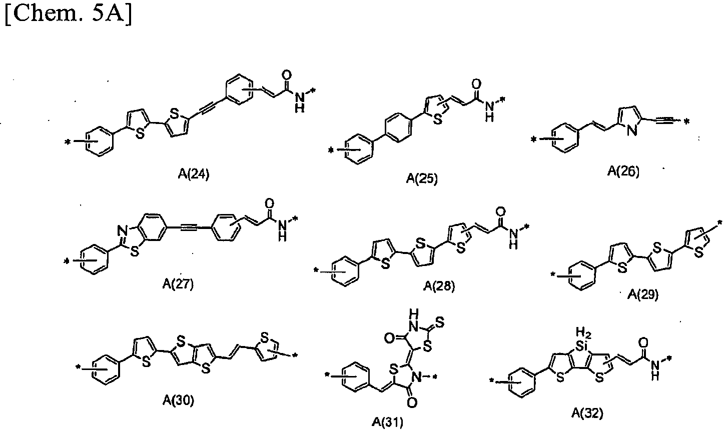

R⁴ and R⁵ in the aforementioned partial structural formula (1) may each independently connect with the partial structure A(1) to A(32) to form a ring.

Among sensitizing dyes in which the π-conjugated group is represented by the aforementioned partial structural formula (1), preferred are compounds in which the partial structure (2) shown below is one of the partial structures (2-1) to (2-14) shown below, because such compounds exhibit particularly excellent characteristics for applications in photoelectric conversion. Particularly preferable are compounds having a skeleton represented by the following partial structure (2-1), (2-2), (2-7), or (2-10), because such compounds are easy to produce and have high photoelectric conversion efficiency.

It should be noted that, in the following partial structures (2) and (2-1) to (2-14), the bonding hand from A¹ to A² is omitted from illustration. In the following partial structures (2-1) to (2-14), the bonding hand from A¹ to A² may be formed on any carbon atom constituting the aromatic hydrocarbon ring or the aromatic hetero ring. 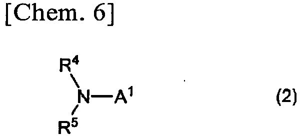 (In the formula, A¹, R⁴, and R⁵ are respectively the same as A¹, R⁴, and R⁵ in the aforementioned partial structural formula (1).) 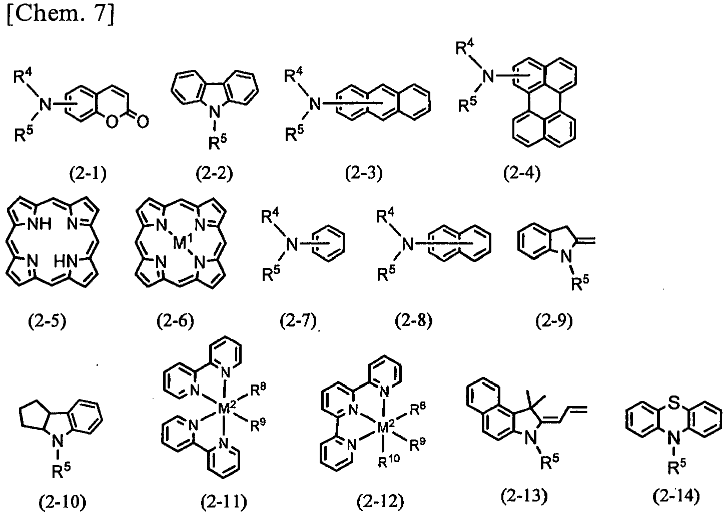 (In the formula, R⁴ and R⁵ are respectively the same as R⁴ and R⁵ in the aforementioned partial structural formula (1), R⁸, R⁹, and R¹⁰ each represent a known ligand that coordinates with M², M¹ and M² each represent a metal element, a hydrogen atom in the formula may be substituted by a fluorine atom, a chlorine atom, an iodine atom, a cyano group, a nitro group, an -OR⁶ group, an -SR⁶ group, or an aliphatic hydrocarbon group that may be substituted, and R⁶ represents a hydrogen atom or a hydrocarbon group that may be substituted.)

In (2-6) representing the aforementioned partial structure (2), concrete examples of the metal element M¹ include Mg, Ca, Sr, Ba, Sc, Y, La, Ce, Pr, Nd, Sm, Eu, Gd, Tb, Dy, Ho, Sn, Yb, Ti, Zr, Hf, V, Nb, Ta, Th, U, Mn, Cu, Cr, Fe, Co, Zn, Mo, Ni, and Rh; inter alia, Cu, Ti, Ni, Fe, and Zn are preferred, and Cu and Zn are more preferred.

In (2-11) and (2-12) representing the aforementioned partial structure (2), examples of the metal element M² include metals capable of tetracoordination or hexacoordination, wherein Ru, Fe, Os, Cu, W, Cr, Mo, Ni, Pd, Pt, Co, Ir, Rh, Re, Mn, and Zn are preferred, Ru, Fe, Os, and Cu are more preferred, and Ru is even more preferred.

In (2-11) and (2-12) representing the aforementioned partial structure (2), examples of the known ligand coordinating with M² and represented by R⁸, R⁹ and R¹⁰ include unidentate, bidentate, and tridentate ligands, and the ligand may be a neutral ligand or an anionic ligand. Although not particularly limited, concrete examples of the ligand preferably include halogen atoms, -NCS, oxalic acid, and PPh(OMe)₂, with halogen atoms and -NCS being more preferred.

The anchor group is not particularly limited so long as it is a group that is adsorbed onto the carrier; normally, a group selected from a carboxylic acid group, a sulfonic acid group, a phosphoric acid group, a phosphonic acid group, an -SiR¹R²R³ (wherein R¹, R², and R³ are each a hydrogen atom, an allyl group, a C₆₋₁₀ aryl group, or a C₁₋₄ alkyl group or alkoxy group) is used. The sensitizing dye (A) only needs to include at least one anchor group, but it may include two or more anchor groups. In cases where there are two or more anchor groups, one type of the aforementioned anchor group may be used, or a plurality of types may be used in combination as the anchor groups. Among the aforementioned anchor groups, the carboxylic acid group and -SiR¹R²R³ are preferred. In cases of using a carboxylic acid group as the anchor group, it is preferable to use two or more anchor groups (two carboxylic acid groups may be used, or one carboxylic acid group and another anchor group may be used in combination). In cases of using -SiR¹R²R³ as the anchor group, it is preferable if at least one of R¹, R², and R³ is a C₁₋₄ alkoxy group, and it is more preferable if all of R¹, R², and R³ are C₁₋₄ alkoxy groups.

The spacer having an atomicity of 5 to 20 in the sensitizing dye (A) is not particularly limited if even one alkylene exists in the spacer. An atomicity of 5 to 20 means that the number of atoms is from 5 to 20 in the shortest connection between the π-conjugated group and the anchor group, and a ring structure may be included therein. The atomicity (number of atoms) is preferably from 6 to 18, more preferably from 7 to 15. The spacer is composed of carbon atoms, oxygen atom(s), nitrogen atom(s), phosphorus atom(s), silicon atom(s), and/or sulfur atom(s) (hydrogen atoms are bonded thereto as appropriate). Inter alia, it is preferable that the spacer is composed of carbon atoms, oxygen atom(s), and /or nitrogen atom(s). Examples of particularly preferable spacers include groups which are combinations of divalent aliphatic hydrocarbons, divalent aromatic hydrocarbons, -CH=CH-, -C=C-, -O-, -CO-, -COO-, -OCO-, -NHCO-, and -NH-(although no two of -O-, -CO-, -COO-, -OCO-, -NHCO-, and -NH- adjoin one another). Note that arylene, -CH=CH-, -C≡C-, and -NHCO- are groups that form a π conjugation, and are thus not directly bonded to the π-conjugated group.

Examples of the divalent aliphatic hydrocarbon usable for the spacer include linear and cyclic divalent saturated aliphatic hydrocarbons, with concrete examples including methane-1,1-diyl, ethane-1,2-diyl, propane-1,3-diyl, butane-1,4-diyl, pentane-1,5-diyl, hexane-1,6-diyl, heptane-1,7-diyl, octane-1,8-diyl, nonane-1,9-diyl, decane-1,10-diyl, and cyclohexane-1,4-diyl. It should be noted that, as a spacer, cyclohexane-1,4-diyl has an atomicity of 4.

Examples of arylenes usable for the spacer include 1,2-phenylene, 1,3-phenylene, and 1,4-phenylene. It should be noted that, as a spacer, 1,2-phenylene has an atomicity of 2, 1,3-phenylene has an atomicity of 3, and 1,4-phenylene has an atomicity of 4.

A hydrogen atom bonded to the spacer may be substituted by a hydrocarbon group that may be substituted, a fluorine atom, a chlorine atom, an iodine atom, a cyano group, a nitro group, a hydroxyl group, a thiol group, or an amino group. Examples of the hydrocarbon group that may be substituted include aliphatic hydrocarbon groups, alicyclic hydrocarbon groups, aromatic hydrocarbon groups, and groups in which a plurality of the above are bonded together. Examples of the aliphatic hydrocarbon groups include the same groups as the groups described as the aforementioned aliphatic hydrocarbon group. Examples of the alicyclic hydrocarbon groups include cyclopropyl, cyclopentyl, cyclohexyl, and cycloheptyl. Examples of the aromatic hydrocarbon groups include phenyl, naphthyl, benzyl, fluorenyl, and indenyl. Examples of groups for substituting the aforementioned groups include a fluorine atom, a chlorine atom, an iodine atom, a bromine atom, a cyano group, a nitro group, a hydroxyl group, a thiol group, or an amino group.

Concrete examples of the sensitizing dye (A) include, although not limited to, compounds Nos. A-1 to A-101 shown below. In the formulas, Me represents a methyl group, Et represents an ethyl group, Bu represents a butyl group, Hex represents a hexyl group, Oct represents an octyl group, and Dec represents a decyl group. It should be noted that Nos. A-95 and A-96 are compounds that do not include the aforementioned partial structural formula (1), but are examples of compounds that are useful as the sensitizing dye (A).

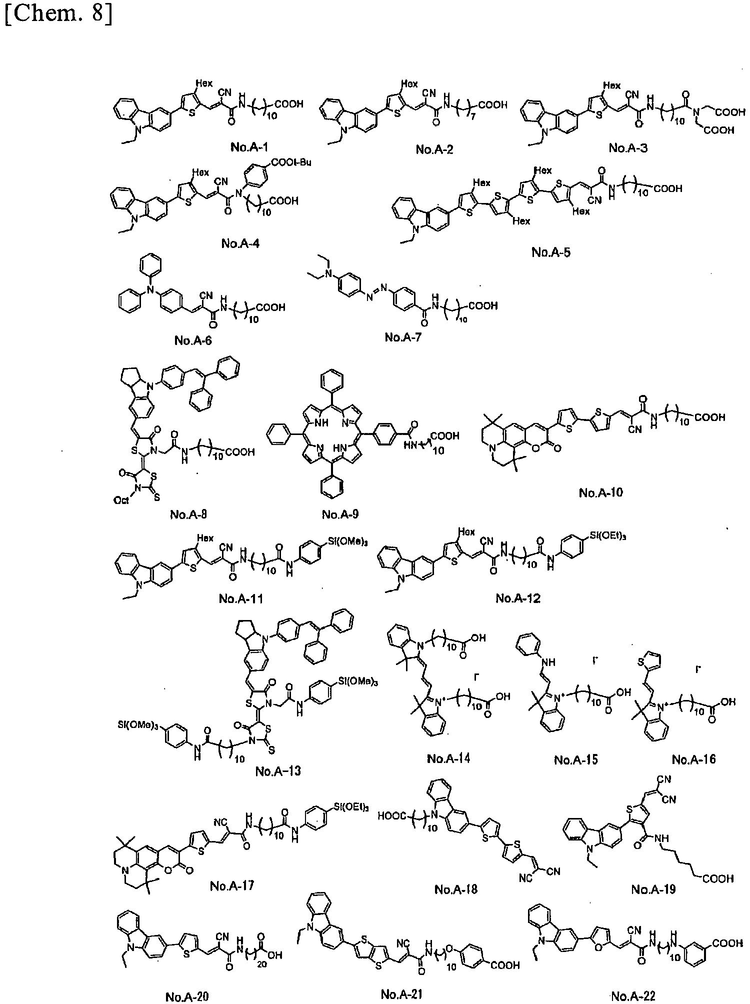

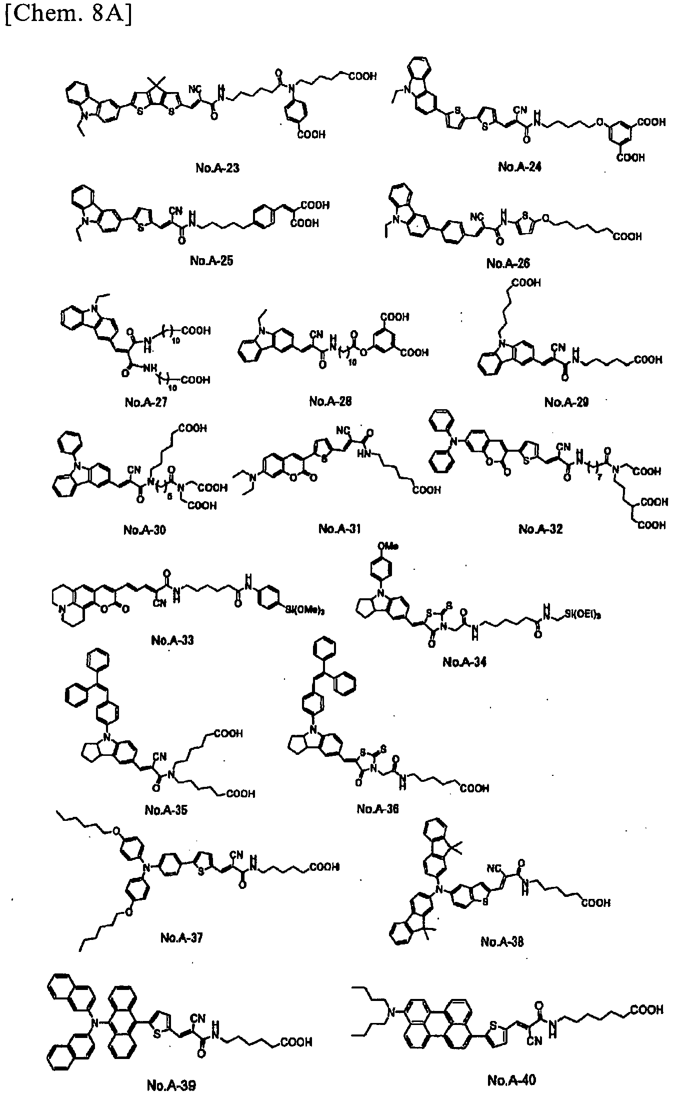

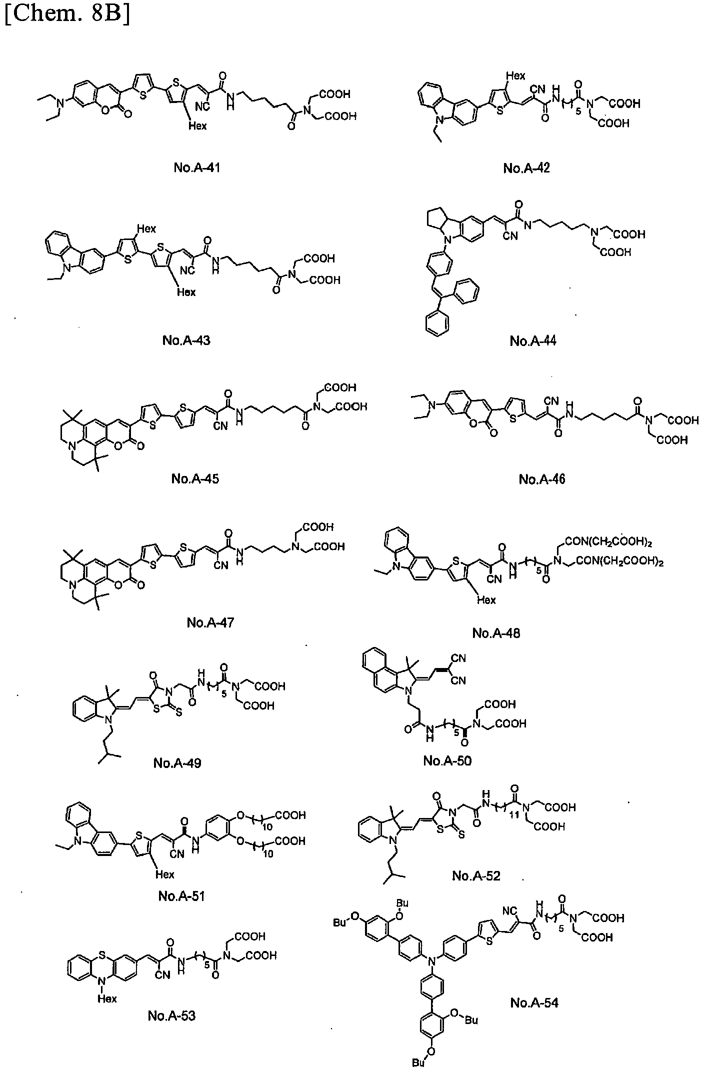

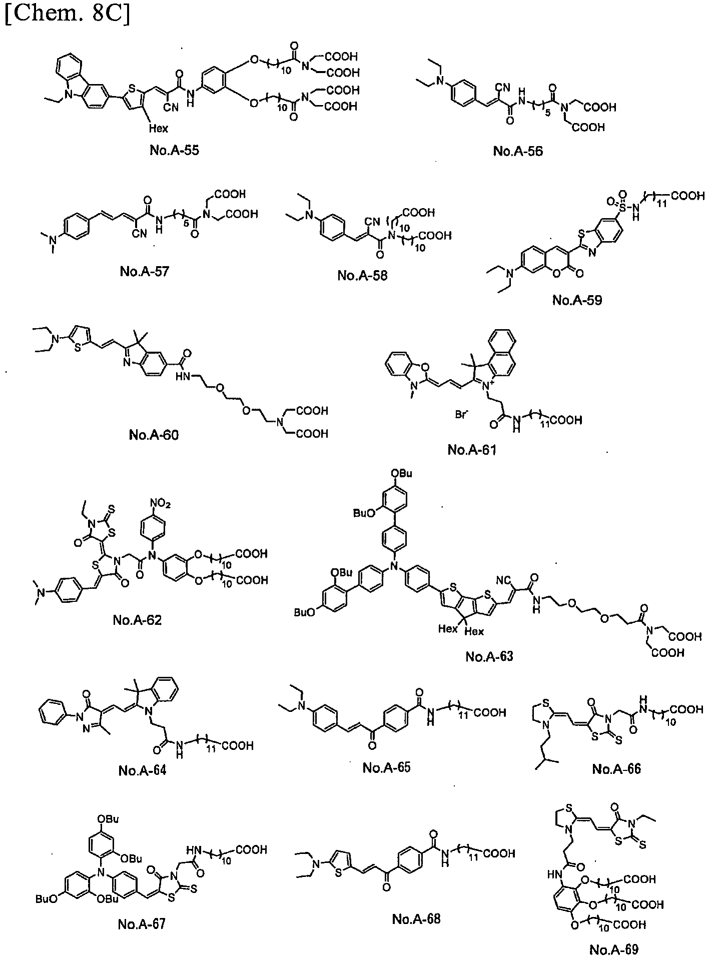

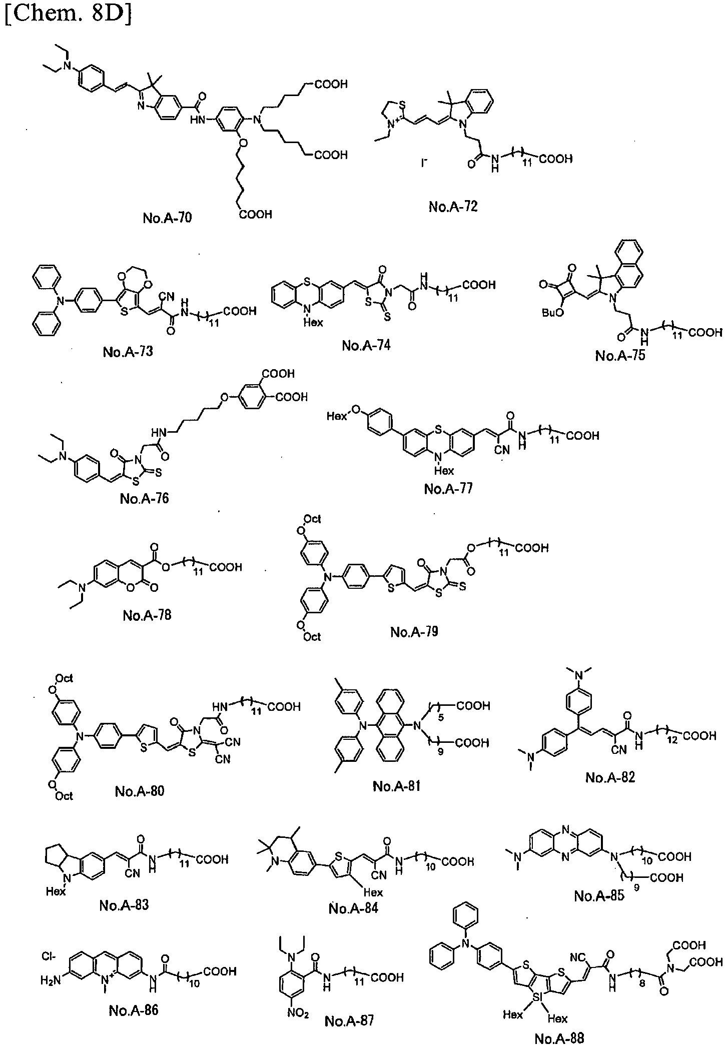

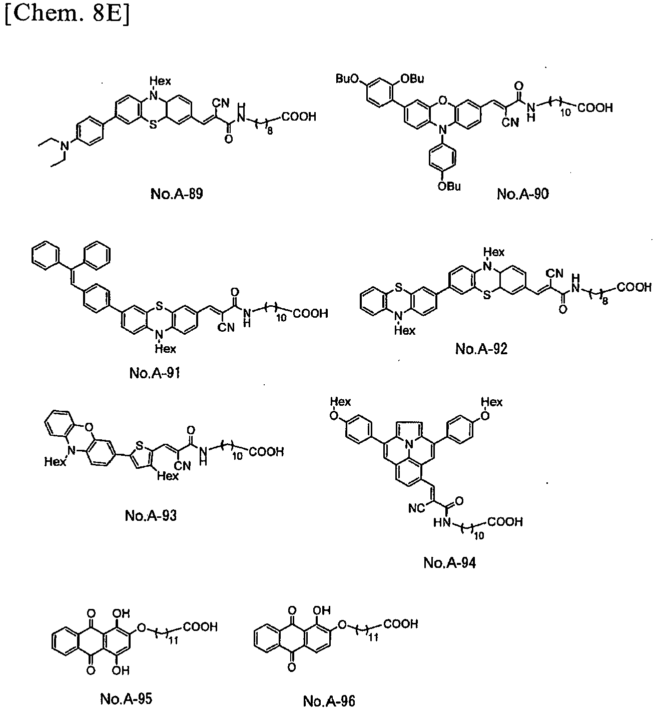

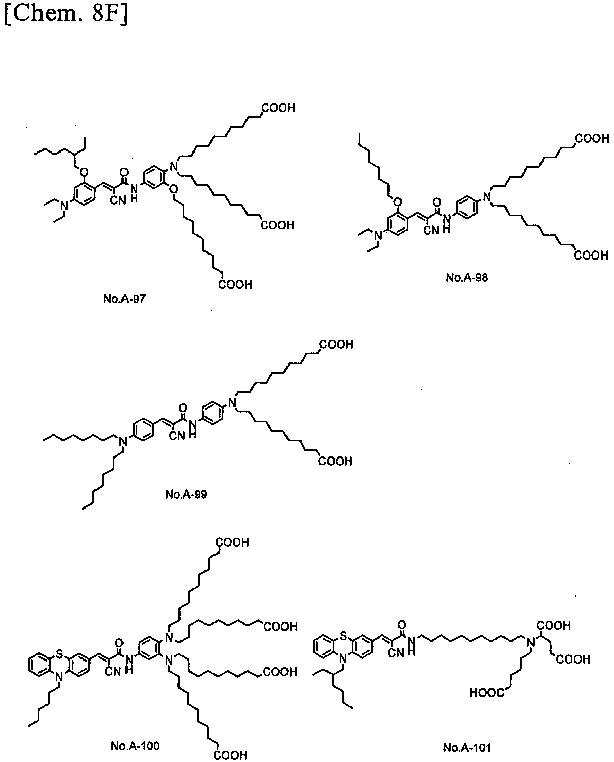

As in the sensitizing dye (A), the π-conjugated group in the sensitizing dye described in (B) above refers to a group that includes consecutively-formed unsaturated bonds and lone pair(s) and that can assume a series of resonance structures.

A hydrogen atom in the π-conjugated group may be substituted by a fluorine atom, a chlorine atom, an iodine atom, a cyano group, a nitro group, an -OR⁴ group, an -SR⁴ group, an -NR⁴R⁵ group, or an aliphatic hydrocarbon group that may be substituted by a fluorine atom, a chlorine atom, an iodine atom, a cyano group, a nitro group, an -OR⁴ group, an -SR⁴ group, or an -NR⁴R⁵ group. R⁴ and R⁵ each represent a hydrogen atom or a hydrocarbon group that may be substituted. The group represented by R⁴ or R⁵ group may be a group having a spacer and an anchor group.

It is preferable if the sensitizing dye (B) includes a nitrogen atom in the π-conjugated group because excellent photoelectric conversion efficiency is achieved.

Examples of the anchor group in the sensitizing dye (B) are the same as those exemplified for the anchor group in the sensitizing dye (A).

The sensitizing dye (B) is not particularly limited so long as a π-conjugated group and at least one anchor group are connected by a direct bond or by a spacer having at least one alkylene and having an atomicity of 1 to 4. Examples of the spacer include groups similar to the examples of the spacer having an atomicity of 5 to 20 in the sensitizing dye (A), except that the spacer in (B) has an atomicity of 1 to 4. Preferred examples of the spacer in the sensitizing dye (B) include various divalent groups, or combinations thereof, exemplified above as preferred examples of the spacer in the sensitizing dye (A). Examples of the sensitizing dye (B) include cyanine-based dyes, indoline-based dyes, xanthene-based dyes, coumarin-based dyes, triarylmethane-based dyes, indigo-based dyes, oxonol-based dyes, porphyrin-based dyes, phthalocyanine-based dyes, azo-based dyes, quinone-based dyes, quinone imine-based dyes, squarylium-based dyes, perylenetetracarboxylic acid derivatives, and ruthenium metal complexes. Inter alia, it is preferable to use a cyanine-based dye, an indoline-based dye, a squarylium-based dye, a ruthenium metal complex, or a porphyrin-based dye, and more preferably a cyanine-based dye or a ruthenium metal complex, in combination with the sensitizing dye (A) in order to widen the absorption wavelength range and improve photoelectric conversion efficiency.

Concrete examples of the sensitizing dye (B) include, although not limited to, compounds Nos. B-1 to B-17 shown below. In the formulas, Bu represents a butyl group, Hex represents a hexyl group, Non represents a nonyl group, and Dec represents a decyl group.

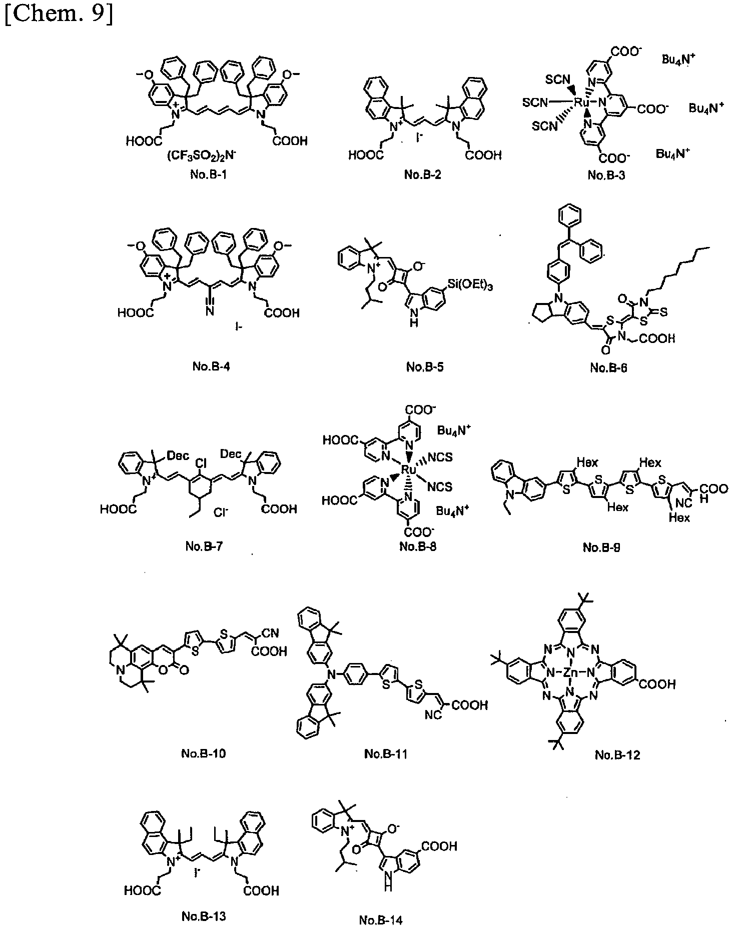

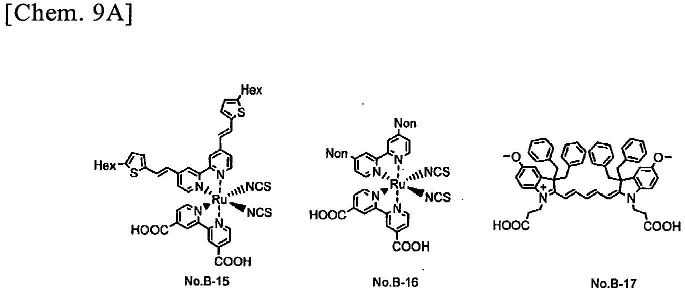

From the objective of using the sensitizing dyes (A) and (B) in combination, it is preferable that the (maximum) absorption wavelength range of the sensitizing dye (A) and the (maximum) absorption wavelength range of the sensitizing dye (B) are different from one another. Normally, it is preferable that the maximum absorption wavelength of (B) is on the long-wavelength side than the maximum absorption wavelength of (A), but this is not absolutely necessary. Normally, it is preferable that the difference between the maximum absorption wavelength of (A) and the maximum absorption wavelength of (B) is from 100 nm to 350 nm, because the absorption wavelength range of the photoelectric conversion device can be widened. It is not preferable if the difference is less than 100 nm, because the absorption wavelength range is not widened sufficiently, and the effect of using a plurality of sensitizing dyes in combination may be diminished. Also, it is not preferable if the difference is greater than 350 nm, because the effect of using the sensitizing dye (A) may be diminished. This is because the electron injection efficiency from the sensitizing dyes to the carrier is low due to the fact that the distance between the carrier and the sensitizing dye, when focusing on (A) alone, is long (because the length of the spacer is long).

In the sensitizing dyes used for the carrier system of the invention, it is preferable that the total ratio of the sensitizing dyes (A) and (B) is from 70 to 100 mol%, and the use of other dyes is from 0 to 30 mol%. Because other dyes do not include an anchor group, the stability of the photoelectric conversion device may deteriorate if the ratio is greater than 30 mol%.

In the carrier system of the invention, the ratio in carrying (fixing) amount between the sensitizing dye (A) and the sensitizing dye (B) is preferably from 0.01 to 100 mol, more preferably from 0.1 to 10 mol, of the sensitizing dye (B) to 1 mol of the sensitizing dye (A).

As methods for fixing the sensitizing dyes used in the carrier system of the invention, it is possible to employ one of various known methods, such as vapor-phase adsorption or liquid-phase adsorption. An example of liquid-phase adsorption is a method of dissolving the sensitizing dyes (A) and (B) in a solvent, and immersing the aforementioned carrier in the solution to cause the dyes to be adsorbed onto the carrier. The carrier system of the invention can be obtained also by dissolving the sensitizing dye (A) and the sensitizing dye (B) in separate solvents, and immersing the carrier in the respective solutions. Another advantage of the present invention is that the dyes can be adsorbed onto the carrier simultaneously by dissolving both the sensitizing dyes (A) and (B) and using a mixed dye solution.

In a preferred method for producing a carrier system of the invention, first, a metal oxide semiconductor layer 12 having a porous structure is formed on the surface of a conductive layer 11B of a conductive substrate 11 by electrodeposition or firing. In the case of employing electrodeposition, for example, an electrolytic bath containing a metal salt providing a metal oxide semiconductor material is heated to a predetermined temperature while bubbling with oxygen or air, the conductive substrate 11 is immersed therein, and a given voltage is applied between the substrate 11 and a counter electrode, thereby to deposit a metal oxide semiconductor material with a porous structure on the conductive layer 11B. The counter electrode may be moved appropriately in the electrolytic bath. In the case of employing firing, for example, powder of a metal oxide semiconductor material is dispersed in a medium to prepare a metal oxide slurry, and the resulting slurry is applied to the conductive substrate 11, then dried, and then fired, to form a porous structure. Then, a dye solution is prepared by dissolving, in an organic solvent, a dye 13 including both the sensitizing dye (A) and the sensitizing dye (B). The conductive substrate 11 having the metal oxide semiconductor layer 12 is immersed in the dye solution, to fix the dye 13 onto the metal oxide semiconductor layer 12.

The carrier system of the present invention which carries the sensitizing dyes (A) and (B) is suited for use in a photoelectric conversion device hereinafter described. The carrier system is also useful in catalysts, toners, and so forth.

Next, the photoelectric conversion device according to the invention is described.

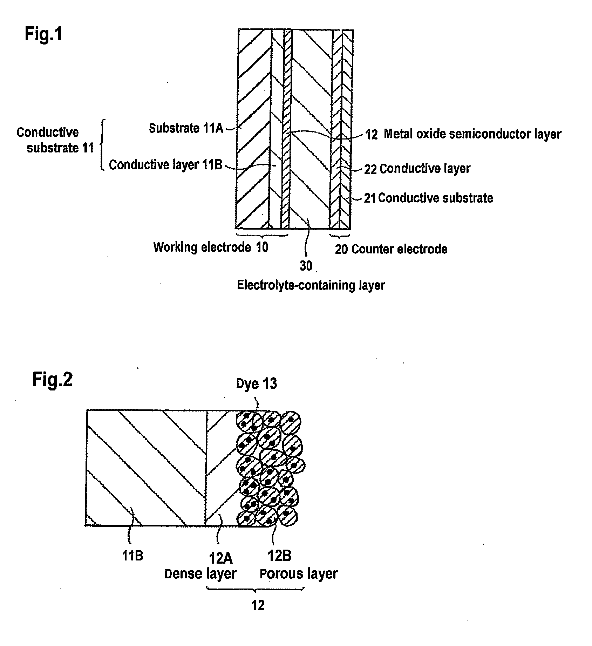

The photoelectric conversion device of the invention is a dye-sensitized photoelectric conversion device having the same structure as conventional dye-sensitized photoelectric conversion devices, except that the sensitizing dyes (A) and (B) are used as dyes. A typical example of the configuration of the photoelectric conversion device of the invention is described with reference to Figs. 1 and 2.

Fig. 1 schematically illustrates a cross-sectional structure of an example of a photoelectric conversion device according to the invention, and Fig. 2 illustrates an enlarged view of an essential part of the photoelectric conversion device illustrated in Fig. 1. The photoelectric conversion device of Figs. 1 and 2 is a principal part of a dye-sensitized solar cell. The photoelectric conversion device includes a working electrode 10 and a counter electrode 20 facing each other across an electrolyte-containing layer 30. At least one of the working electrode 10 and the counter electrode 20 is light-transmissive.

The working electrode 10 has, for example, a conductive substrate 11, a metal oxide semiconductor layer 12 provided on one surface of the substrate 11 (on the surface facing the counter electrode 20), and a dye 13 carried on the metal oxide semiconductor layer 12. In the photoelectric conversion device of the invention, the dye 13 includes at least one type of sensitizing dye listed in (A) and at least one type of sensitizing dye listed in (B), and the carrier system according to the invention is a composite system composed of the dye 13 and the metal oxide semiconductor layer 12 carrying the dye.

The working electrode 10 functions as a negative electrode to an outer circuit. The conductive substrate 11 is, for example, composed of an insulating substrate 11A and a conductive layer 11B provided on the surface of the insulating substrate 11A.

Suitable materials of the substrate 11A include insulating materials, such as glass and plastics. Plastics are used, for example, in the form of transparent polymer film. Examples of plastics for forming a transparent polymer film include tetraacetyl cellulose (TAC), polyethylene terephthalate (PET), polyethylene naphthalate (PEN), syndiotactic polystyrene (SPS), polyphenylene sulfide (PPS), polycarbonate (PC), polyarylate (PAR), polysulfone (PSF), polyester sulfone (PES), polyetherimide (PEI), cyclic polyolefins, and brominated phenoxy resins.

The conductive layer 11 B is, for example, a thin film of an electroconductive metal oxide, such as indium oxide, tin oxide, indium-tin complex oxide (ITO), or fluorine-doped tin oxide (FTO or F-SnO₂), a thin film or mesh of a metal, such as gold (Au), silver (Ag), or platinum (Pt), or an electroconductive polymer film/mesh.

It should be noted that the conductive substrate 11 may be, for example, a single-layer structure made of an electroconductive material. In this case, examples of the material of the conductive substrate 11 include electroconductive metal oxides, such as indium oxide, tin oxide, indium-tin complex oxide, or fluorine-doped tin oxide, metals, such as gold, silver, or platinum, and electroconductive polymers.

The metal oxide semiconductor layer 12 is a carrier carrying the dye 13. It has, for example, a porous structure as illustrated in Fig. 2. The metal oxide semiconductor layer 12 is formed of a dense layer 12A and a porous layer 12B. The dense layer 12A is formed on the interface with the conductive substrate 11 and is preferably dense and less-porous, more preferably filmy. The porous layer 12B is formed on the surface in contact with the electrolyte-containing layer 30. It preferably has a structure with many voids and a large surface area, more preferably a structure composed of porous particles adhering to one another. The metal oxide semiconductor layer 12 may have, for example, a single-layer structure of film form. In the invention, "carry (fix)" refers to a state in which the dye 13 is bonded or adsorbed to the porous layer 12B chemically, physically, or electrically.

Examples of the material (metal oxide semiconductor material) contained in the metal oxide semiconductor layer 12 include titanium oxide, zinc oxide, tin oxide, niobium oxide, indium oxide, zirconium oxide, tantalum oxide, vanadium oxide, yttrium oxide, aluminum oxide, and magnesium oxide. Inter alia, as for the metal oxide semiconductor material, titanium oxide and zinc oxide are preferred, for they provide high conversion efficiency. These metal oxide semiconductor materials may be used either individually or in combination of two or more thereof (in the form, e.g., of mixture, mixed crystal, solid solution, or one covering the surface of another). For example, titanium oxide and zinc oxide may be used in combination.

The metal oxide semiconductor layer 12 having a porous structure can be formed by, for example, electrodeposition, coating, or firing. Electrodeposition to form the metal oxide semiconductor layer 12 is carried out by immersing the conductive substrate 11 in an electrolytic bath containing a particulate metal oxide semiconductor material to cause the particles to adhere to the conductive layer 11B of the conductive substrate 11, thereby making the metal oxide semiconductor material precipitate thereon. In the case of forming the metal oxide semiconductor layer 12 by the coating method, a dispersion of a particulate metal oxide semiconductor material (metal oxide slurry) is applied to the conductive substrate 11 and then dried to remove the dispersing medium. In the case of forming the metal oxide semiconductor layer 12 by the firing method, the metal oxide slurry is applied to the conductive substrate 11 and dried in the same manner as in the coating method, followed by firing. Forming the metal oxide semiconductor layer 12 by the electrodeposition or coating method is advantageous in that a less heat-resistant plastic material or polymer film material is allowed to be used to form the substrate 11 A, thereby making it possible to provide a highly flexible electrode.

The metal oxide semiconductor layer 12 may be treated with an organic base, a urea derivative, or a cyclic saccharide chain. Examples of the organic base include diarylamines, triarylamines, pyridine, 4-t-butylpyridine, polyvinylpyridine, quinoline, piperidine, and amidines. The treatment may be effected either before or after the hereinafter described adsorption of the dye 13. The treatment may be carried out by immersion. In using a solid treating agent, the treating agent is dissolved in an organic solvent to prepare a solution, in which the metal oxide semiconductor layer 12 is immersed.

The dye 13 is, for example, in a state adsorbed onto the metal oxide semiconductor layer 12. The dye 13 includes at least one dye (sensitizing dye) capable of being excited on absorbing incident light and injecting electrons to the metal oxide semiconductor layer 12. In the photoelectric conversion device of the invention, at least one type of the aforementioned sensitizing dye (A) and at least one type of the aforementioned sensitizing dye (B) correspond to the dye 13. When at least one type of the aforementioned sensitizing dye (A) and at least one type of the aforementioned sensitizing dye (B) are used as the dye 13, the dye 13 as a whole achieves an increased rate of electron injection into the metal oxide semiconductor layer 12 per unit quantity of incident light, thereby improving conversion efficiency.

The dye 13 only needs to include at least one type of the aforementioned sensitizing dye (A) and at least one type of the aforementioned sensitizing dye (B), and may include other dyes. Examples of other dyes include dyes that contain no anchor group.

The dye 13 may contain, in addition to the above described dyes, one or more additives, such as dye association inhibitors which suppress the association of compounds in the dyes, concrete examples thereof including cholic acid compounds represented by chemical formula (14) below. These compounds may be used either individually or as a mixture of two or more thereof. 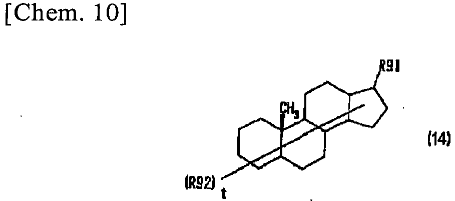 (In the formula, R91 represents an alkyl group having an acidic group or an alkoxysilyl group; R92 represents a group bonded to any of carbon atoms constructing the steroid skeleton in the chemical formula, and is selected from a hydroxyl group, a halogen atom, an alkyl group, an alkoxy group, an aryl group, a heterocyclic group, an acyl group, an acyloxy group, an oxycarbonyl group, an oxo group, an acidic group, an alkoxysilyl group, and derivatives of these groups; a plurality of R92 groups may be the same or different; t represents an integer of 1 to 5; and the bond between the carbon atoms constructing the steroid skeleton in the chemical formula may be either a single bond or a double bond.)

The counter electrode 20 is composed, e.g., of a conductive substrate 21 and a conductive layer 22 provided thereon and functions as a positive electrode to an outer circuit. Examples of materials for making the conductive substrate 21 include those described for making the substrate 11 A of the conductive substrate 11 of the working electrode 10. The conductive layer 22 comprises, for example, at least one electroconductive material and, if necessary, a binder. Examples of the electroconductive material for use in the conductive layer 22 include metals, such as platinum, gold, silver, copper (Cu), rhodium (Rh), ruthenium (Ru), aluminum (Al), magnesium (Mg), and indium (In), carbon (C), and electroconductive polymers. Examples of the binder for use in the conductive layer 22 include acrylic resins, polyester resins, phenol resins, epoxy resins, cellulose, melamine resins, fluoroelastomers, and polyimide resins. The counter electrode 20 may have, for example, a single-layer structure formed of the conductive layer 22.

The electrolyte-containing layer 30 comprises, for example, a redox electrolyte containing an oxidation-reduction couple. Examples of the redox electrolyte include an I⁻/I₃⁻ couple, a Br⁻/Br₃⁻ couple, a quinone/hydroquinone couple, a cobalt complex, and a nitroxy radical compound. Specifically, the redox electrolyte is exemplified by a halide/halogen couple, such as an iodide/iodine couple or a bromide/bromine couple. Examples of the halide include a cesium halide, a quaternary alkylammonium halide, an imidazolium halide, a thiazolium halide, an oxazolium halide, a quinolinium halide, and a pyridinium halide. Specifically, examples of the iodide include: cesium iodide; quaternary alkylammonium iodides, such as tetraethylammonium iodide, tetrapropylammonium iodide, tetrabutylammonium iodide, tetrapentylammonium iodide, tetrahexylammonium iodide, tetraheptylammonium iodide, and trimethylphenylammonium iodide; imidazolium iodides, such as 3-methylimidazolium iodide and 1-propyl-2,3-dimethylimidazolium iodide; thiazolium iodides, such as 3-ethyl-2-methyl-2-thiazolium iodide, 3-ethyl-5-(2-hydroxyethyl)-4-methylthiazolium iodide, and 3-ethyl-2-methylbenzothiazolium iodide; oxazolium iodides, such as 3-ethyl-2-methylbenzoxazolium iodide; quinolinium iodides, such as 1-ethyl-2-methylquinolinium iodide; and pyridinium iodides. Examples of the bromides include quaternary alkylammonium bromides. Of the halide/halogen couples, preferred are couples of at least one of the above listed iodides and iodine.

The redox electrolyte may be, for example, a combination of an ionic liquid and a halogen. In this case, the redox electrolyte may further contain the above described halide. Examples of the ionic liquid include those usable in electric batteries and solar cells, such as those disclosed in Inorg. Chem. (1996, 35, pp. 1168-1178), Electrochemistry (2002, 2, pp. 130-136), JP 9-507334T, and JP 8-259543A. As for the ionic liquid, preferred are salts whose melting point is below room temperature (25°C) or salts whose melting point is higher than room temperature but which are liquefied at room temperature on dissolving with other fused salt. Specific examples of the ionic liquids are anions and cations described below.

Examples of cations of ionic liquids are ammonium, imidazolium, oxazolium, thiazolium, oxadiazolium, triazolium, pyrrolidinium, pyridinium, piperidinium, pyrazolium, pyrimidinium, pyradinium, triazinium, phosphonium, sulfonium, carbazolium, indolium, and derivatives thereof. They may be used either individually or as a mixture of two or more thereof. Specific examples include 1-methyl-3-propylimidazolium, 1-butyl-3-methylimidazolium, 1,2-dimethyl-3-propylimidazolium, and 1-ethyl-3-methylimidazolium.

Examples of anions of ionic liquids include: metal chloride ions, e.g., AlCl₄⁻ and Al₂Cl₇⁻; fluorine-containing anions, such as PF₆⁻, BF₄⁻, CF₃SO₃⁻, N(CF₃SO₂)₂⁻, F(HF)n⁻, and CF₃COO⁻; fluorine-free compound ions, such as NO₃⁻, CH₃COO⁻, C₆H₁₁COO⁻, CH₃OSO₃⁻, CH₃OSO₂⁻, CH₃SO₃⁻, CH₃SO₂⁻, (CH₃O)₂PO₂⁻, N(CN)₂⁻, and SCN⁻; and other halide ions, such as iodide ions and bromide ions. These anions may be used either individually or as a mixture of two or more thereof. Preferred of these anions of ionic liquids are iodide ions.

For the electrolyte-containing layer 30, it is possible to use a liquid electrolyte (electrolyte solution) prepared by dissolving the aforementioned redox electrolyte in a solvent or a solid polymer electrolyte in which an electrolyte solution is held in a polymer matrix. The electrolyte-containing layer 30 may also be a pseudo-solid (pasty) electrolyte containing a mixture of an electrolyte solution and a particulate carbon material, such as carbon black. The pseudo-solid electrolyte containing a carbon material does not need to contain a halogen simple substance in the electrolyte because the carbon material functions to catalyze the oxidation-reduction reaction. The redox electrolyte may contain one or more organic solvents capable of dissolving the aforementioned halide or ionic liquid. Examples of such organic solvents include electrochemically inert solvents, such as acetonitrile, tetrahydrofuran, propionitrile, butyronitrile, methoxyacetonitrile, 3-methoxypropionitrile, valeronitrile, dimethyl carbonate, ethylmethyl carbonate, ethylene carbonate, propylene carbonate, N-methylpyrrolidone, pentanol, quinoline, N,N-dimethylformamide, γ-butyrolactone, dimethyl sulfoxide, and 1,4-dioxane.

For the purpose of improving power generation efficiency, durability, and the like of the photoelectric conversion device, the electrolyte-containing layer 30 may contain acyclic saccharides (see JP 2005-093313A), pyridine compounds (see JP 2003-331936A), urea derivatives (see JP 2003-168493A), sheet clay minerals (see JP 2007-531206T), dibenzylidene D-sorbitol, cholesterol derivatives, amino acid derivatives, trans-(1R,2R)-1,2-cyclohexanediamine alkylamide derivatives, alkylurea derivatives, N-octyl-D-gluconamide benzoate, double-headed amino acid derivatives, quaternary ammonium derivatives, and so on.

When light (sunlight or ultraviolet, visible, or near-infrared light equal to sunlight) is incident on the dye 13 carried in the working electrode 10 in the photoelectric conversion device of the invention, the dye 13 absorbs the light, and the thus excited dye 13 injects electrons into the metal oxide semiconductor layer 12. The electrons move to the adjacent conductive layer 11B, passes through an outer circuit, and reach the counter electrode 20. On the other hand, the electrolyte in the electrolyte-containing layer 30 is oxidized to return (reduce) the dye 13, which has been oxidized with the movement of electrons, to its ground state. The thus-oxidized electrolyte is reduced upon receipt of the electrons having reached the counter electrode 20. In this way, the electron movement between the working electrode 10 and the counter electrode 20 and the associated oxidation-reduction reaction in the electrolyte-containing layer 30 are repeated, whereby electrons move continuously to steadily perform photoelectric conversion.

The photoelectric conversion device of the invention can be produced, for example, as follows.

First, a working electrode 10 is prepared. First of all, a metal oxide semiconductor layer 12 having a porous structure is formed on the surface of the conductive layer 11B of the conductive substrate 11 by electrodeposition or firing. In the case of employing electrodeposition, for example, an electrolytic bath containing a metal salt providing a metal oxide semiconductor material is heated to a predetermined temperature while bubbling with oxygen or air, the conductive substrate 11 is immersed therein, and a given voltage is applied between the substrate 11 and a counter electrode, thereby to deposit a metal oxide semiconductor material with a porous structure on the conductive layer 11B. The counter electrode may be moved appropriately in the electrolytic bath. In the case of employing firing, for example, powder of a metal oxide semiconductor material is dispersed in a medium to prepare a metal oxide slurry, and the resulting slurry is applied to the conductive substrate 11, then dried, and then fired, to form a porous structure. Then, a dye solution is prepared by dissolving, in an organic solvent, a dye 13 including at least one type of the aforementioned sensitizing dye (A) and at least one type of the aforementioned sensitizing dye (B). The conductive substrate 11 having the metal oxide semiconductor layer 12 is immersed in the dye solution, to fix the dye 13 onto the metal oxide semiconductor layer 12.

The concentration of each of the sensitizing dyes (A) and (B) in the dye solution is preferably 1.0 × 10⁻⁵ to 1.0 × 10⁻³ mol/dm³, more preferably 5.0 × 10⁻⁵ to 5.0 × 10⁷⁴ mol/dm³. The organic solvent used to prepare the dye solution is not particularly limited as long as it is capable of dissolving the sensitizing dyes (A) and (B), and concrete examples include: hydrocarbons, such as toluene, benzene, and xylene; alcohols, such as methanol, ethanol, and t-butanol; ether alcohols, such as methyl cellosolve, ethyl cellosolve, butyl cellosolve, and butyl diglycol; ketones, such as acetone, methyl ethyl ketone, methyl isobutyl ketone, cyclohexanone, and diacetone alcohol; esters, such as ethyl acetate, butyl acetate, and methoxyethyl acetate; acrylic esters, such as ethyl acrylate and butyl acrylate; fluoroalcohols, such as 2,2,3,3-tetrafluoropropanol; chlorinated hydrocarbons, such as methylene dichloride, dichloroethane, and chloroform; acetonitrile; and tetrahydrofuran. These organic solvents may be used in any combination thereof. Preferred solvents are toluene, acetonitrile, and alcohols, with acetonitrile and alcohols being more preferred.

A conductive layer 22 is then formed on one surface of a conductive substrate 21 to prepare a counter electrode 20. The conductive layer 22 can be formed by, for example, sputtering an electroconductive material.

The working electrode 10 and the counter electrode 20 are assembled with a predetermined space therebetween using a spacer (not illustrated), such as a sealant, such that the surface of the working electrode 10 carrying the dye 13 and the surface of the counter electrode 20 provided with the conductive layer 22 face each other, and the entire assembly is sealed, for example, while leaving an inlet for injecting an electrolyte. Subsequently, an electrolyte is injected through the inlet into the space between the working electrode 10 and the counter electrode 20, followed by sealing the inlet, to form the electrolyte-containing layer 30. In this way, the photoelectric conversion device illustrated in Figs. 1 and 2 is completed.

While the photoelectric conversion device has been described with particular reference to the configuration in which the electrolyte-containing layer 30 is provided between the working electrode 10 and the counter electrode 20, the electrolyte-containing layer 30 may be replaced with a solid charge transfer layer. In that case, the solid charge transfer layer includes, for example, a material in which carrier transfer through the solid is relevant to electric conduction. Such a material is preferably an electron transport material or a hole transport material.

The hole transport material is preferably, for example, an aromatic amine or a triphenylene derivative, and examples include organic electroconductive polymers, such as oligothiophene compounds, polypyrrole, polyacetylene or its derivatives, poly(p-phenylene) or its derivatives, poly(p-phenylenevinylene) or its derivatives, polythienylenevinylene or its derivatives, polythiophene or its derivatives, polyaniline or its derivatives, polytoluidine or its derivatives, and the like.

A p-type inorganic compound semiconductor may be used as the hole transport material. The p-type inorganic compound semiconductor preferably has a band gap of 2 eV or greater, more preferably 2.5 eV or greater. The ionization potential of the p-type inorganic compound semiconductor must be smaller than that of the working electrode 10 in order to secure the condition for reducing the positive holes of the dye. The ionization potential of the p-type inorganic compound semiconductor, while varying depending on the dye used, is preferably from 4.5 to 5.5 eV inclusive, more preferably from 4.7 to 5.3 eV inclusive.

Examples of the p-type inorganic compound semiconductor include compound semiconductors containing monovalent copper. Examples of compound semiconductors containing monovalent copper include CuI, CuSCN, CuInSe₂, Cu(In,Ga)Se₂, CuGaSe₂, Cu₂O, CuS, CuGaS₂, CuInS₂, and CuAlSe₂. Other examples of the p-type inorganic compound semiconductor include GaP, NiO, CoO, FeO, Bi₂O₃, MoO₂, and Cr₂O₃.

The solid charge transfer layer may, for example, be formed directly on the working electrode 10, and then the counter electrode 20 may be formed thereon.

The hole transport material including the organic photoconductive polymer may be introduced into the inside of the electrode by, for example, vacuum deposition, casting, coating, spin coating, dipping, electrolytic polymerization, or photo-induced electrolytic polymerization. Also for inorganic solid compounds, the hole transport material may be introduced into the inside of the electrode by, for example, casting, coating, spin coating, dipping, or electroplating. It is preferred that part of the thus-formed solid charge transport layer (particularly a layer containing the hole transport material) partially penetrates into the voids of the porous structure of the metal oxide semiconductor layer 12 to come into direct contact with the metal oxide semiconductor material.

The combination of the sensitizing dyes (A) and (B) can improve conversion efficiency of a photoelectric conversion device that has a solid charge transfer layer instead of the electrolyte-containing layer 30, just like in the case of a photoelectric conversion device having the electrolyte-containing layer 30.

The use of the photoelectric conversion device of the invention is not limited to the aforementioned solar cell, and the photoelectric conversion device finds other uses, such as photosensors.

Next, the compound of the present invention is described below. Examples of the groups represented by R⁴', R⁵', A¹', and A²' in the aforementioned partial structural formula (1') respectively include the same groups as R⁴, R⁵, A¹, and A² in the aforementioned partial structural formula (1). Examples of the anchor group in the compound of the present invention include the same groups exemplified as the anchor group in the sensitizing dye (A) used in the carrier system of the invention. Examples of the spacer in the compound of the present invention include the same groups exemplified as the spacer in the sensitizing dye (A) used in the carrier system of the invention. The compound of the present invention is a novel compound that corresponds to the sensitizing dye (A) used in the carrier system of the invention. Among the compounds of the present invention, preferred are: compounds that include a group represented by (A2'-9) or (A2'-15) in A² in the aforementioned partial structural formula (1'); and compounds in which the following partial structure (2') in the aforementioned partial structural formula (1') has one of the following partial structures (2'-1) to (2'-14). More preferred are compounds in which the following partial structure (2') has the following partial structure (2'-1) or (2'-2), and even more preferred are compounds in which the following partial structural formula (2') has the following partial structure (2'-2). 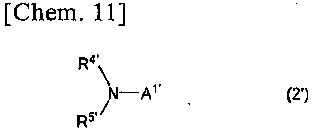 (In the formula, A¹', R⁴', and R⁵' are respectively the same as A¹', R⁴', and R⁵' in the aforementioned partial structural formula (1').) 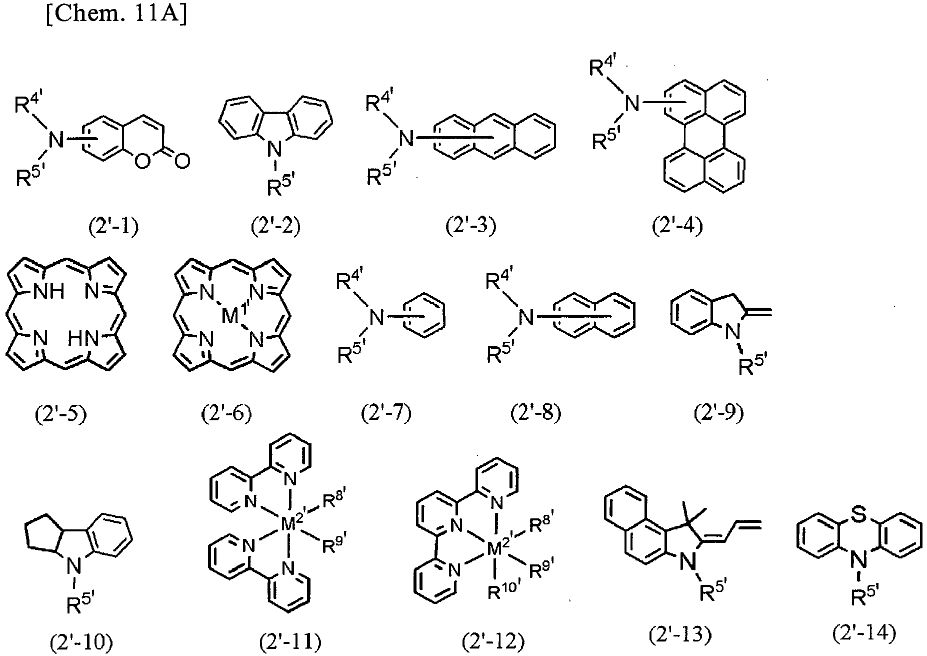 (In the formula, R⁴' and R⁵' are respectively the same as R⁴' and R⁵' in the aforementioned partial structural formula (2'), R⁸', R⁹', and R¹⁰' each represent a known ligand that coordinates with M²', M¹' and M²' each represent a metal element, a hydrogen atom in the formula may be substituted by a fluorine atom, a chlorine atom, an iodine atom, a cyano group, a nitro group, an -OR⁶' group, an -SR⁶' group, or an aliphatic hydrocarbon group that may be substituted, and R⁶' represents a hydrogen atom or a hydrocarbon group that may be substituted.)

The compound of the present invention can be obtained by a method that employs known or general well-known reactions, and the method for synthesis is not particularly limited. An example of a typical synthesis method is described below. This example describes a case where the anchor group is a carboxylic acid group, but other compounds including other anchor groups can be produced in the same way by changing, as appropriate, the compound (5') shown below.

The following describes the synthesis method for a case in which: the spacer is bonded to A²' in the partial structural formula (1'); A²' is a group obtained by connecting two or more groups selected from groups represented by the aforementioned partial structural formulas (A2'-1) to (A2'-19); and a portion of A²' is the aforementioned partial structural formula (A2'-16) that bonds with the spacer. In the reaction equation shown below, portions in A²' other than the aforementioned (A2'-16) are described as Ar²'. A conjugate (4')--in which Ar²' in the partial structure represented by the aforementioned formula (1') is substituted by a carboxyl group--is transformed into an acid chloride, and is then reacted with a secondary amine compound (5') in which the carboxyl group is protected, to thereby synthesize an amide (6'). Then, by deprotecting (6') with trifluoroacetic acid, a compound represented by (3') is obtained. 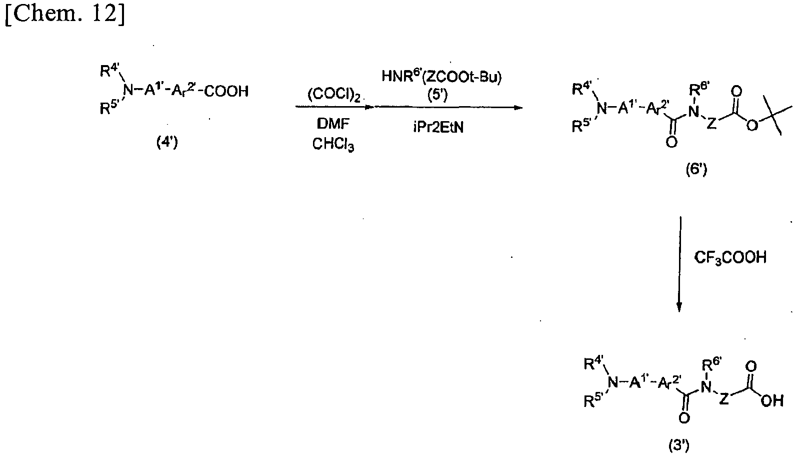 (In the formula, A¹', R⁴', and R⁵' are respectively the same as A¹', R⁴', and R⁵' in the partial structural formula (1'), R⁶' is the same as R⁶' in the aforementioned partial structural formula (A2'-16), and Z is the same as the spacer defined for the aforementioned sensitizing dye (A).)

The novel compound of the present invention can be suitably used in applications such as photoelectric conversion devices in the form of a carrier system wherein the compound is carried by a carrier as described above. The present compound also finds applications as: intermediates for optical recording materials, pharmaceuticals, agricultural chemicals, aroma chemicals, and dyes; various functional materials, starting materials for various polymers; photoelectrochemical cells, nonlinear optical devices, electrochromic displays, holographic devices, organic semiconductors, organic ELs; silver halide photographic materials, photosensitizers; colorants in printing inks, inkjet inks, electrophotographic color toners, cosmetics, and plastics; stains for proteins, luminescent dyes for substance detection; material for making artificial quartz; paints, synthetic catalysts, catalyst carriers, surface coating thin film materials, silicone rubber crosslinking agents, binders; and so on.

### EXAMPLES

The present invention is described in further detail below according to examples for synthesizing the novel compound of the invention, examples of the carrier system (working electrode) of the invention made by using the compounds synthesized according to the examples, and comparative examples thereof. The present invention, however, is not limited to the examples.

The aforementioned Compound No. A-1 was synthesized by the following Example 1-1.

### Example 1-1: Synthesis of Compound No. A-1

In a flask were placed the following Compound No. B2-1 (0.88 mmol; 400 mg), dimethylformamide (1 ml), and chloroform (10 ml); oxalyl chloride (0.97 mmol; 123 mg) was added thereto, and the mixture was stirred for 1 hour. Then, tertiary-butyl 11-aminoundecanoate (0.97 mmol; 248 mg) and diisopropylethylamine (1.75 mmol; 226 mg) were added at 0°C, and the mixture was stirred for 1 hour. Water (20 ml) and chloroform (20 ml) were added to the reaction solution, and the solution was subjected to oil-water separation. The obtained organic layer was refined by silica gel column chromatography (mobile phase: chloroform), to obtain 550 mg of an orange solid (yield: 90%). This solid was dissolved in dichloromethane (5 ml) and cooled to 0°C, and trifluoroacetic acid (0.9 mmol; 103 mg) was added thereto, and the mixture was stirred for 10 minutes. Then, the temperature was raised to room temperature, and the mixture was further stirred for 12 hours. The solvent was removed by evaporation, and the resultant product was refined by silica gel column chromatography (mobile phase: chloroform:methanol = 10:1), to obtain 505 mg of a yellow solid (yield: 100%). It was verified by UV-VIS (λmax), ¹H-NMR, and IR that the obtained solid was Compound No. A-1. Data are shown in Tables 1 to 3.

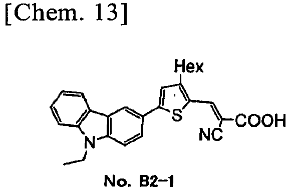

### Examples 1-2 to 1-10: Synthesis of Compounds Nos. A-2 to A-10

Compounds Nos. A-2 to A-10 were synthesized according to the same method as that for Example 1-1, except that carboxylic-acid-containing compounds and amine compounds corresponding to the respective target compounds were used. The outer appearance and yield of each compound are indicated in Table 1. It was verified, according to the same methods as in Example 1-1, that the synthesized compounds were the target compounds. Data are shown in Tables 1 to 3.

### Example 1-11: Synthesis of Compound No. A-11

In a flask were placed Compound No. A-1 (0.05 mmol; 30 mg), dimethylformamide (0.1 ml), and chloroform (2 ml); oxalyl chloride (0.06 mmol; 8 mg) was added thereto, and the mixture was stirred for 1 hour. Then, 4-trimethoxysilylaniline (0.05 mmol; 10 mg) and diisopropylethylamine (0.09 mmol; 12 mg) were added at 0°C, and the mixture was stirred for 1 hour. Water (10 ml) and chloroform (10 ml) were added to the reaction solution, and the solution was subjected to oil-water separation. The obtained organic layer was refined by silica gel column chromatography (mobile phase: chloroform), to obtain 30 mg of an orange solid (yield: 38%). It was verified by UV-VIS (λmax), ¹H-NMR, and IR that the obtained solid was Compound No. A-11. Data are shown in Tables 1 to 3.

### Examples 1-12 and 1-13: Synthesis of Compounds Nos. A-12 and A-13

Compounds Nos. A-12 and A-13 were synthesized according to the same method as that for Example 1-11, except that carboxylic-acid-containing compounds and amine compounds corresponding to the respective target compounds were used. The outer appearance and yield of each compound are indicated in Table 1. It was verified, according to the same methods as in Example 1-1, that the synthesized compounds were the target compounds. Data are shown in Tables 1 to 3.

### Example 1-14: Synthesis of Compound No. A-14

In a flask were placed the following Material 1 (1.89 g), N,N'-diphenylformamidine (0.39 g), acetic anhydride (0.25 g), and pyridine (8 ml), and the mixture was stirred at 80°C for 2 hours. Chloroform (10 ml) and water (10 ml) were added thereto, and then the solution was subjected to oil-water separation. The organic layer was refined in a silica gel column (chloroform:methanol = 10:1), to obtain 40 mg of Compound No. A-14, the target product. It was verified, according to the same methods as in Example 1-1, that the synthesized compound was the target compound. Data are shown in Tables 1 to 3.

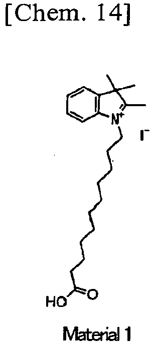

### Example 1-15: Synthesis of Compound No. A-15

In a flask were placed Material 1 (4.71 g), N,N'-diphenylformamidine (2.94 g), and ethanol (10 ml), and the mixture was stirred at 70°C for 1 hour. Chloroform (20 ml) and water (20 ml) were added thereto, and then the solution was subjected to oil-water separation. The organic layer was refined in a silica gel column (chloroform:methanol = 10:1), to obtain 2.74 g of Compound No. A-15, the target product. It was verified, according to the same methods as in Example 1-1, that the synthesized compound was the target compound. Data are shown in Tables 1 to 3.

### Example 1-16: Synthesis of Compound No. A-16

In a flask were placed Material 1 (1.00 g), chloroform (3.60 g), 2-thiophene carboxyaldehyde (0.24 g), and piperazine (0.018 g), and the mixture was stirred at 60°C for 2 hours. Chloroform (10 ml) and water (10 ml) were added thereto, and the solution was subjected to oil-water separation. The organic layer was refined in a silica gel column (chloroform:methanol = 10:1), to obtain 0.81 g of Compound No. A-16, the target product. It was verified, according to the same methods as in Example 1-1, that the synthesized compound was the target compound. Data are shown in Tables 1 to 3.

### Examples 1-17 to 1-33: Synthesis of Compounds Nos. A-41 to A-57

Compounds Nos. A-41 to A-57 were synthesized according to the same method as that for Example 1-1, except that carboxylic-acid-containing compounds and amine compounds corresponding to the respective target compounds were used. The outer appearance and yield of each compound are indicated in Table 1. It was verified, according to the same methods as in Example 1-1, that the synthesized compounds were the target compounds. Data are shown in Tables 1 to 3.

**[Table 1]**

| | Compound | Outer appearance | Yield/% | λmax/nm |
|---|---|---|---|---|
| Example 1-1 | No. A-1 | Yellow solid | 90 | 447 (CHCl₃) |
| Example 1-2 | No. A-2 | Orange solid | 49 | 447 (CHCl₃) |
| Example 1-3 | No. A-3 | Orange solid | 65 | 447 (CHCl₃) |
| Example 1-4 | No. A-4 | Yellow solid | 59 | 441 (CHCl₃) |
| Example 1-5 | No. A-5 | Brown solid | 99 | 481 (CHCl₃) |
| Example 1-6 | No. A-6 | Yellow liquid | 97 | 426 (CHCl₃) |
| Example 1-7 | No. A-7 | Purple solid | 67 | 430 (CHCl₃) |
| Example 1-8 | No. A-8 | Black solid | 91 | 550 (CHCl₃) |
| Example 1-9 | No. A-9 | Purple solid | 95 | 419 (CHCl₃) |
| Example 1-10 | No. A-10 | Red solid | 98 | 518 (CHCl₃) |
| Example 1-11 | No. A-11 | Orange solid | 38 | 447 (CHCl₃) |
| Example 1-12 | No. A-12 | Orange solid | 65 | 447 (CHCl₃) |
| Example 1-13 | No. A-13 | Dark-brown solid | 15 | 555 (CHCl₃) |
| Example 1-14 | No. A-14 | Reddish-brown solid | 2 | 559 (CHCl₃) |
| Example 1-15 | No. A-15 | Orange solid | 48 | 424 (CHCl₃) |
| Example 1-16 | No. A-16 | Brown solid | 68 | 437 (CHCl₃) |
| Example 1-17 | No. A-41 | Black solid | 76 | 498 (EtOH) |
| Example 1-18 | No. A-42 | Orange solid | 66 | 431 (EtOH) |
| Example 1-19 | No. A-43 | Green solid | 89 | 463 (EtOH) |
| Example 1-20 | No. A-44 | Orange solid | 61 | 441 (EtOH) |
| Example 1-21 | No. A-45 | Orange solid | 68 | 508 (EtOH) |
| Example 1-22 | No. A-46 | Orange solid | 68 | 488 (EtOH) |
| Example 1-23 | No. A-47 | Orange solid | 88 | 508 (EtOH) |
| Example 1-24 | No. A-48 | Orange solid | 100 | 487 (EtOH) |
| Example 1-25 | No. A-49 | Reddish-brown solid | 100 | 439 (EtOH) |
| Example 1-26 | No. A-50 | Ocher solid | 100 | 447 (EtOH) |
| Example 1-27 | No. A-51 | Orange solid | 99 | 450 (MeOH) |
| Example 1-28 | No. A-52 | Vermilion solid | 100 | 502 (EtOH) |
| Example 1-29 | No. A-53 | Reddish-purple solid | 98 | 432 (EtOH) |
| Example 1-30 | No. A-54 | Vermilion solid | 100 | 468 (EtOH) |
| Example 1-31 | No. A-55 | Orange solid | 97 | 452 (MeOH) |
| Example 1-32 | No. A-56 | Yellow solid | 100 | 410 (EtOH) |
| Example 1-33 | No. A-57 | Green solid | 100 | 445 (EtOH) |

**[Table 2A]**

| Example | ¹H NMR |
|---|---|
| 1-1 (CDCl₃) | 8.52 (s, 1H), 8.40 (s, 1H), 8.17 (d, 1H), 7.79 (d, 1H), 7.50 (dd, 1H), 7.44-7.40 (m, 2H), 7.30 (s, 1H), 7.28 (d, 1H), 6.34 (br, 1H), 4.39 (q, 2H), 3.41 (q, 2H), 2.84 (t, 2H), 2.36 (t, 2H), 1.72-1.58 (m, 6H), 1.46 (t, 3H), 1. 40-1.26 (m, 18H), 0.90 (t, 3H) |
| 1-2 (CDCl₃) | 8.51 (s, 1H), 8.41 (s, 1H), 8. 17 (d, 1H), 7.80 (d, 1H), 7.51 (dd, 1H), 7.44-7.28 (m, 4H), 6.29 (br, 1H), 4.39 (q, 2H), 3.41 (q, 2H), 2.83 (t, 2H), 2.36 (t, 2H), 1.72-1.58 (m, 6H), 1.47 (t, 3H), 1.41-1.30 (m, 12H), 0.90 (t, 3H) |
| 1-3 (CDCl₃) | 8.42 (s, 1H), 8.27 (s, 1H), 8.07 (d, 1H), 7.67 (d, 1H), 7.43 (dd, 1H), 7.32 (dd, 1H), 7.30-7.18 (m, 3H), 6.49 (br, 1H), 4.23 (q, 2H), 4.18-3.90 (m, 4H), 3.33 (t, 2H), 2.74 (t, 2H), 2.24 (t, 2H), 1.65-1.48 (m, 6H), 1.40-1.19 (m, 21H), 0.84 (t, 3H) |
| 1-4 (CDCl₃) | 8.35 (s, 1H), 8.34 (s, 1H), 8.17-8.13 (m, 3H), 7.72 (d, 1H), 7.55 (d, 1H), 7.35-7.25 (m, 6H), 4.33 (q, 2H), 3.89 (t, 2H), 2.81 (t, 2H), 2.34 (t, 2H), 1.69-1.22 (m, 36H), 0.92 (t, 3H) |
| 1-5 (DMSO-d) | 8.44 (s, 1H), 8.29 (br, 1H), 8.20 (d, 1H), 8.19 (s, 1H), 7.71 (d, 1H), 7.60 (d, 2H), 7.46 (dd, 1H), 7.43 (s, 1H), 7.20 (d, 1H), 7.19 (s, 1H), 7.09 (s, 1H), 7.06 (s, 1H), 4.43 (q, 2H), 3.18 (t, 2H), 2.81-2.70 (m, 8H), 2.16 (t, 2H), 1.71-1.53 (m, 8H), 1.49-1.45 (m, 4H), 1.19-1.38 (m, 36H), 0.84 (t, 12H) |
| 1-6 (CDCl₃) | 8.17 (s, 1H), 7.77 (d, 2H), 7.33 (dd, 4H), 7.16 (m, 6H), 6.96 (m, 2H), 6.34 (t, 1H), 3.40 (q, 2H), 2.35 (t, 4H), 1. 59 (m, 4H), 1. 29 (m, 12H) |
| 1-7 (MeOH-d) | 7.92 (d, 2H), 7.88 (d, 2H), 7.82 (d, 2H), 6.93 (d, 2H), 3.39 (t, 2H), 3.17 (s, 6H), 2.26 (t, 2H), 1.66-1.56 (m, 4H), 1.43-1.27 (m, 12H) |
| 1-8 (CDCl₃) | 7.69 (s, 1H), 7.41-7.27 (m, 13H), 7.04 (d, 2H), 6.94-6.91 (m, 2H), 5.93 (t, 1H), 4.85 (t, 1H), 4.72 (s, 2H), 4.06 (t, 2H), 3.83 (t, 1H), 3.30 (q, 2H), 2.35 (t, 2H), 1.86-1.28 (m, 33H), 0.88 (t, 3H) |
| 1-9 (CDCl₃) | 8.85 (d, 2H), 8.84 (d, 4H), 8.77 (d, 2H), 8.28 (d, 2H), 8.21-8.17 (m, 6H), 8.13 (d, 2H), 7.80-7.70 (m, 10H), 6.44 (br, 1H), 3.60 (q, 2H), 2.35 (t, 2H), 1.79-1.60 (m, 4H), 1.45-1.32 (m, 12H) |
| 1-10 (MeOH-d) | 8.25 (s, 1H), 8.23 (s, 1H), 7.70 (d, 1H), 7.62 (d, 1H), 7.42 (d, 1H), 7.36 (d, 1H), 7.36 (s, 1H), 3.39-3.30 (m, 6H), 2.25 (t, 2H), 1.84 (t, 2H), 1.77 (t, 2H), 1.62-1.54 (m, 4H), 1.37-1.28 (m, 24H) |
| 1-11 (CDCl₃) | 8.51 (s, 1H), 8.40 (s, 1H), 8.16 (d, 1H), 7.80 (d, 1H), 7.61-7.57 (m, 2H), 7.50 (dd, 1H), 7.45-7.39 (m, 4H), 7.32-7.27 (m, 2H), 6.69 (br, 1H), 6.34 (br, 1H), 4.38 (q, 2H), 3.59 (s, 9H), 3.42 (t, 2H), 2.80 (t, 2H), 2.35 (t, 2H), 1.75-1.58 (m, 6H), 1.49-1.29 (m, 21H), 0.89 (t, 3H) |

| | |
|---|---|
| Continued to the following Table 2B | |

**[Table 2B]**

| | |
|---|---|
| 1-12 (CDCl₃) | 8.50 (s, 1H), 8.39 (s, 1H), 8.15 (d, 1H), 7.79 (d, 1H), 7.63-7.38 (m, 8H), 7.25 (d, 1H), 6.29 (br, 1H), 4.36 (q, 2H), 3.85 (q, 6H), 3.42 (t, 2H), 2.81 (t, 2H), 2.35 (t, 2H), 1.75-1.59 (m, 8H), 1.49-1.20 (m, 25H), 0. 87 (t, 3H) |
| 1-13 (CDCl₃) | 7.40-7.20 (m, 21H), 7.04 (q, 4H), 6.94 (s, 2H), 4.90 (s, 2H), 4.80 (t, 1H), 4.10 (t, 1H), 3.80 (m, 14H), 2.30 (t, 2H), 2.20-1.00 (m, 42H) |
| 1-14 (CDCl₃) | 8.51 (d, 1H), 7.56 (d, 1H), 7.49-7.39 (m, 6H), 7.31 (t, 1H), 7.25 (t, 1H), 7.16 (d, 1H), 4.10 (t, 2H), 2.33 (t, 2H), 1.87 (quin, 2H), 1.71 (s, 6H), 1.63-1.51 (m, 4H), 1.38-1.28 (m, 10H) |
| 1-15 (CDCl₃) | 8.43 (t, 1H), 7.41-7.37 (m, 4H), 7.26-7.11 (m, 6H), 4.22 (t, 4H), 2.32 (t, 4H), 1.86 (quin, 4H), 1.72 (s, 12H), 1.66-1.53 (m, 8H), 1.35-1.26 (m, 20H) |
| 1-16 (CDCl₃) | 8.61 (d, 1H), 8.48 (d, 1H), 7.82 (d, 1H), 7.61-7.53 (m, 6H), 7.36 (d, 1H), 7.28 (dd, 1H), 4.81 (t, 2H), 2.34 (t, 2H), 1.98 (tt, 2H), 1.90 (s, 6H), 1.61-1.45 (m, 4H), 1.40-1.21 (m, 10H) |
| 1-17 (DMSO-d6) | 8.54(s, 1H), 8.32(t, 1H), 8.21(t, 1H), 7.73(d, 1H), 7.58(d, 1H), 7.52(d, 1H), 7.49(s, 1H), 6.79(d, 1H), 6.61(s, 1H), 4.05(d, 4H), 3.46(q, 4H), 3. 18 (q, 2H), 2. 79 (t, 2H), 2.24(t, 2H), 1.64-1.57(m, 2H), 1.52-1.44 (m, 4H), 1.29(quin, 8H), 1.14(t, 6H), 0. 85 (t, 3H) |
| 1-18 (MeOH-d4) | 8.41(s, 1H), 8.34(s, 1H), 8.14(d, 1H), 7.77(d, 1H), 7.52-7.43(m, 4H), 7.23(t 1H), 4.41(q, 2H), 4.43(s, 2H), 4.00(s, 2H), 3.32(t, 2H), 2.82(t, 2H), 2.39(t, 2H), 1.72-1.55(m, 6H), 1.46-1.30(m, 11H), 0.90(t, 3H) |
| 1-19 (CDCl₃) | 8.47(s, 1H), 8.30(s, 1H), 8. 13(d, 1H), 7.70(d, 1H), 7.49(t, 1H), 7.40(d, 2H), 7.25(t, 1H), 7.21(s, 1H), 7.09(s, 1H), 6. 62 (t, 1H), 4.37(q, 2H), 4.24(s, 4H), 3. 42 (q, 2H), 2.87(t, 2H), 2.81(t, 2H), 2.38(t, 2H), 1.80-1.69(m, 4H), 1.69-1.53(m, 4H), 1.53-1.27(m, 17H), 0.91(t, 6H) |
| 1-20 (CDCl₃) | 8.00(s, 1H), 7. 71 (s, 1H), 7.46(d, 1H), 7.31-7.17(m, 12H), 6.93-6.72(m, 8H), 4.70(t, 1H), 4.16(s, 2H), 4.10(s, 2H), 3. 66 (t, 1H), 3.29(q, 2H), 2.29(t, 2H), 1. 94-1. 31 (m, 13H) |
| 1-19 (CDCl₃) | 8.47(s, 1H), 8.30(s, 1H), 8. 13 (d, 1H), 7.70(d, 1H), 7.49(t, 1H), 7.40(d, 2H), 7.25(t, 1H), 7.21(s, 1H), 7.09(s, 1H), 6. 62 (t, 1H), 4. 37 (q, 2H), 4.24(s, 4H), 3. 42 (q, 2H), 2.87(t, 2H), 2.81(t, 2H), 2.38(t, 2H), 1.80-1.69(m, 4H), 1. 69-1. 53 (m, 4H), 1.53-1.27(m, 17H), 0.91(t, 6H) |
| 1-20 (CDCl₃) | 8.00(s, 1H), 7.71(s, 1H), 7.46(d, 1H), 7. 31-7. 17 (m, 12H), 6. 93-6. 72 (m, 8H), 4.70(t, 1H), 4.16(s, 2H), 4.10(s, 2H), 3. 66 (t, 1H), 3.29(q, 2H), 2.29(t, 2H), 1.94-1.31(m, 13H) |
| 1-21 (MeOH-d4) | 8.21(d, 2H), 7.69(s, 1H), 7.61(s, 1H), 7.40(s, 1H), 7.50(s, 2H), 4.07(d, 4H), 3.59-3.28(m, 6H), 2.36(t, 2H), 1.84(t, 2H), 1.76(t, 2H), 1.67-1.56(m, 10H), 1.40-1.28(m, 6H) |

| | |
|---|---|
| Continued to the following Table 2C | |

**[Table 2C]**

| | |
|---|---|
| 1-22 (MeOH-d4) | 8.61(s, 1H), 8.28(s, 1H), 8.20(t, 1H), 7.83(q, 2H), 7.66(d, 1H), 6.80(d, 1H), 6.64(s, 1H), 4.16(s, 2H), 3.95(s, 2H), 3.47(q, 4H), 3.18(q, 2H), 2.24(t, 2.05), 1.49(m, 4H), 1.27(m, 2H), 1.15(t, 6H) |
| 1-23 (MeOH-d4) | 8.23(s, 1H), 8.16(s, 1H), 7.60(s, 1H), 7.60(s, 1H), 7.37(s, 1H), 7.36(s, 1H), 7.33(s, 1H), 4.20(s, 4H), 3.42-3.30(m, 8H), 1.86-1.70(m, 4H), 1.70-1.50(m, 4H), 1.30(s, 6H) |
| 1-24 (MeOH-d4) | 8.41(s, 1H), 8.35(s, 1H), 8.17(s, 1H), 7.89(s, 1H), 7.75 (d, 1H), 7.57(d, 1H), 7.46-7.41(m, 3H), 7.22(t, 1H), 4.45-4.09(m, 12H), 3.86(s, 4H), 3.30(t, 2H), 2.81(t, 2H), 2.32(m, 2H), 1.67-1.64(m, 6H), 1.39-1.35(m, 11H), 0.90 (t, 3H) |
| 1-25 (CDCl₃) | 7.89(d, 1H), 7.18(m, 2H), 7.05(t, 1H), 6.83(d, 1H), 5.20(d, 1H), 4.76(s, 2H), 4.23(s, 2H), 4.16(s, 2H), 3.73(t, 2H), 3.21(q, 2H), 2.36(t, 2H), 1.8-1.2(m, 15H), 1.04(d, 6H) |
| 1-26 (MeOH-d4) | 8.59(d, 1H), 8.15(d, 1H), 7.89(m, 2H), 7.54(t, 1H), 7.46(d, 1H), 7.37(t, 1H), 7.20(t, 1H), 5.92(d, 1H), 4.33(t, 2H), 3.84(s, 4H), 3.01(q, 2H), 2.66(t, 2H), 1.95(ts, 8H), 1.4-0.9(m, 6H) |
| 1-27 (DMSO-d6) | 8.65(s, 1H), 8.33(s, 1H), 8.30(d, 1H), 7.86(d, 1H), 7.74(s, 1H), 7.73(d, 1H), 7.66(d, 1H), 7.50(t, 1H), 7. 34(s, 1H), 7.26(d, 1H), 7.20(d, 1H), 6.91(d, 1H), 4.48(q, 2H), 3.92(t, 4H), 2.86(t, 2H), 2.16(m, 4H), 1.69(m, 6H), 1.50-1.20(m, 39H), 0.85(t, 3H) |
| 1-28 (CDCl₃) | 7.95(d, 1H), 7.29(m, 2H), 7.10(t, 1H), 6.88(d, 1H), 6.43(t, 1H), 5.25(d, 1H), 4.79(s, 2H), 4.21(ss, 4H), 3.76(t, 2H), 3.26(q, 2H), 2.34(t, 2H), 1.8-1.2(m, 27H), 1.07(d, 6H) |
| 1-29 (MeOH-d4) | 7.98(s, 1H), 7.80(d, 1H), 7.74(s, 1H), 7.19(t, 1H), 7.10(d, 1H), 7.1-6.9(m, 3H), 4.25(s, 2H), 4.11(s, 2H), 3.97(t, 2H), 2.38(t, 2H), 1.78(m, 2H), 1.62(m, 4H), 1.43(m, 4H), 1.30(m, 4H), 0.86(t, 3H) |
| 1-30 (CDCl₃) | 8.31(s, 1H), 7.62(d, 1H), 7.45(m, 6H), 7.24(m, 3H), 7.12(m, 6H), 6.66(t, 1H), 6.54(sd, 4H), 4.22(ss, 4H), 3.96(m, 8H), 3.38(q, 2H), 2.37(t, 2H), 1.9-1.2(m, 22H), 0.9(t, 6H), 0.91(t, 6H) |
| 1-31 (MeOH-d4) | 8.38(s, 2H), 8.11(d, 2H), 7.74(d, 2H), 7.50-7.40(m, 4H), 7.31(S, 1H), 7.21(t, 1H), 7.07(d, 1H), 6.83(d, 1H), 4.35(d, 2H), 4.23(s, 4H), 4.12(s, 4H), 3.95(t, 2H), 3.89(t, 2H), 2.80(t, 2H), 2.32(q, 4H), 1.80-1.20(m, 35H), 0.89(t, 3H) |
| 1-32 (MeOH-d4) | 7.95(s, 1H), 7.85(d, 2H), 6.77(d, 2H), 4.25(s, 2H), 4.11(s, 2H), 3.47(q, 4H), 3.30(q, 2H), 2.37(t, 2H), 1.61(m, 4H), 1.39(m, 2H), 1.18(t, 6H) |
| 1-33 (DMSO-d6) | 8.14(s, 1H), 7.89(d, 1H), 7.51(d, 2H), 7.34(d, 1H), 6.89(t, 1H), 6.74(d, 2H), 4.16(s, 2H), 3.95(s, 2H), 3.14(q, 2H), 3.01(s, 6H), 2.24(t, 2H), 1.47(m, 4H), 1.25(m, 2H) |

**[Table 3A]**

| <IR-ATR> | |
|---|---|
| Example | IR / cm⁻¹ |
| 1-1 | 3291, 3049, 2922, 2852, 2217, 2216, 1725, 1624, 1596, 1533, 1488, 1480, 1420, 1381, 1325, 1272, 1187, 1156, 1124, 1088, 1060 |
| 1-2 | 3342, 2923, 2853, 2205, 1711, 1636, 1597, 1565, 1527, 1490, 1421, 1380, 1331, 1231, 1198, 1152, 1124, 1088, 1023 |
| 1-3 | 3338, 2920, 2850, 2201, 1705, 1671, 1603, 1576, 1515, 1427, 1388, 1303, 1217, 1111, 1053 |
| 1-5 | 3220, 2920, 2850, 2201, 1734, 1647, 1598, 1567, 1521, 1490, 1450, 1412, 1378, 1330, 1273, 1231, 1204, 1151, 1021 |
| 1-6 | 3340, 2924, 2852, 2204, 1707, 1659, 1573, 1524, 1504, 1489, 1431, 1333, 1312, 1269, 1217, 1189, 1178, 1074, 1046, 1027 |
| 1-7 | 3343, 2915, 2848, 1732, 1696, 1628, 1598, 1521, 1466, 1429, 1362, 1269, 1173, 1134 |
| 1-8 | 3263, 2921, 2851, 1703, 1673, 1563, 1531, 1507, 1482, 1452, 1424, 1361, 1304, 1262, 1162, 1123, 1027 |
| 1-9 | 3315, 2920, 2849, 1703, 1606, 1540, 1471, 1439, 1348, 1301, 1212, 1174, 1151, 1109, 1070, 1031 |
| 1-10 | 3338, 2920, 2850, 2201, 1705, 1670, 1575, 1516, 1427, 1389, 1350, 1331, 1302, 1270, 1218, 1112, 1052 |
| 1-11 | 3316, 2923, 2852, 2200, 1659, 1570, 1517, 1490, 1469, 1422, 1381, 1346, 1276, 1232, 1131, 1087 |
| 1-13 | 3322, 2921, 2851, 1673, 1577, 1532, 1507, 1482, 1360, 1305, 1264, 1028 |
| 1-14 | 2922, 2851, 1074, 1628, 1585, 1544, 1482, 1465, 1406, 1369, 1321, 1301, 1258, 1177, 1118, 1050, 1019 |
| 1-15 | 2922, 2850, 1705, 1550, 1477, 1453, 1419, 1368, 1345, 1240, 1154, 1133, 1101, 1039, 1015 |
| 1-16 | 2921, 2850, 1719, 1578, 1535, 1497, 1464, 1399, 1350, 1335, 1294, 1173, 1095, 1047, 1016 |
| 1-17 | 3317, 2925, 2209, 1739, 1706, 1616, 1590, 1542, 1527, 1512, 1490, 1414, 1396, 1350, 1256, 1229, 1213, 1180, 1157, 1131, 1077 |
| 1-18 | 2926, 2856, 2201, 1731, 1625, 1565, 1528, 1489, 1470, 1420, 1381, 1345, 1231, 1153, 1132, 1087, 1059, 1023 |
| 1-19 | 2925, 2855, 2198, 1732, 1627, 1568, 1528, 1489, 1465, 1446, 1417, 1345, 1298, 1231, 1087, 1058 |
| 1-20 | 2931, 2202, 1641, 1564, 1506, 1483, 1452, 1424, 1383, 1323, 1286, 1264, 1233, 1181, 1137, 1105 |
| 1-21 | 2931, 2206, 1576, 1529, 1429, 1390, 1288, 1201, 1127, 1063 |
| 1-22 | 3301, 2939, 2221, 1705, 1658, 1612, 1585, 1556, 1536, 1512, 1501, 1451, 1429, 1411, 1354, 1264, 1237, 1209, 1181, 1131, 1108, 1081, 1054, 1014 |
| 1-23 | 3371, 2939, 2361, 1736, 1666, 1643, 1580, 1511, 1428,1363, 1331, 1302, 1269, 1236, 1218, 1155, 1134, 1057, 1039 |
| 1-24 | 2925, 2856, 1731, 1632, 1567, 1527, 1483, 1420, 1349, 1298, 1188, 1130 |

**[Table 3B]**

| | |
|---|---|
| 1-25 | 2928, 1731, 1639, 1527, 1485, 1466, 1404, 1382, 1320, 1174, 1135, 1115, 1048, 1016 |
| 1-26 | 2928, 2197, 1645, 1539, 1515, 1466, 1442, 1366, 1294, 1237, 1181, 1132, 1015 |
| 1-27 | 3284, 2914, 2848, 2209, 1701, 1650, 1627, 1599, 1564, 1531, 1511, 1490, 1470, 1422, 1351, 1330, 1298, 1276, 1233, 1172, 1154, 1125, 1062, 1018 |
| 1-28 | 2920, 2860, 2360, 2337, 1728, 1638, 1530, 1485, 1466, 1404, 1382, 1321, 1174, 1135, 1114, 1048, 1016 |
| 1-29 | 2926, 2855, 2207, 2167, 1735, 1635, 1587, 1568, 1528, 1494, 1462, 1404, 1367, 1286, 1242, 1206, 1174, 1041 |
| 1-30 | 2930, 2867, 1728, 1599, 1576, 1519, 1491, 1466, 1432, 1321, 1268, 1226, 1179, 1133, 1064, 1030, 1002 |
| 1-31 | 2921, 2851, 2207, 1729, 1599, 1568, 1526, 1509, 1489, 1469, 1421, 1383, 1331, 1223, 1125, 1023 |
| 1-32 | 2927, 2200, 1731, 1606, 1566, 1510, 1440, 1409, 1362, 1326, 1273, 1234, 1183, 1154, 1075, 1009 |
| 1-33 | 2931, 2207, 1729, 1633, 1591, 1519, 1408, 1368, 1287, 1226, 1166 |

### Production of Titanium Oxide Carrier (Conductive Substrate 11):

A conductive substrate 11 made of an electroconductive glass substrate F-SnO₂) measuring 2.0 cm in length, 1.5 cm in width, and 1.1 mm in thickness was prepared. A 70-µm-thick masking tape was stuck on the conductive substrate 11 to surround a square region having a length of 0.5 cm and a width of 0.5 cm. 3 cm³ of a metal oxide slurry prepared by suspending titanium oxide powder (TiO₂; Ti-Nanoxide D from Solaronix) in water in a concentration of 10 wt% was applied to the square region to a uniform thickness and dried. After the masking tape on the conductive substrate 11 was removed, the substrate was fired in an electric oven at 450°C, to form a metal oxide semiconductor layer 12 with a thickness of about 5 µm.

### Production of Zinc Oxide Carrier (Working Electrode) (Conductive Substrate 11):

According to the same method as that for the aforementioned titanium oxide carrier, a conductive substrate 11 was produced, except that this conductive substrate included a zinc oxide carrier prepared by using a metal slurry made of zinc oxide powder (average particle diameter: 20 nm; FINEX-50 from Sakai Chemical Industry Co., Ltd.) instead of the aforementioned titanium oxide powder.

### Example 2-1:

### Electrode Including Dye (B) Only:

A dye solution was prepared by dissolving Compound No. B-1 in toluene such that the concentration was 3×10⁻⁴ mol/dm³. Then, a conductive substrate 11 including a zinc oxide carrier was immersed in the dye solution, to thereby prepare a working electrode 10 carrying the dye 13.

### Electrode Including Both Dyes (A) and (B):

A dye solution was prepared by dissolving Compound No. A-1 and Compound No. B-1 in toluene such that the concentration of each compound was 3×10⁻⁴ mol/dm³. Then, a conductive substrate 11 including a zinc oxide carrier was immersed in the dye solution, to thereby prepare a working electrode 10 carrying the dye 13.

### Production of Photoelectric Conversion Device and Evaluation of Conversion Efficiency:

A photoelectric conversion device was prepared by: arranging, across a spacer (63 µm), the prepared working electrode 10 in opposition to a counter electrode 20 prepared by coating an ITO electrode (from Nishinoda Denko Co., Ltd.)--which serves as a conductive substrate 21--with graphite particulates (conductive layer 22) such that an electrolyte-containing layer 30 was arranged therebetween, as illustrated in Fig. 1; fixing the stack with a clip; and introducing, into the electrolyte-containing layer 30, an electrolyte solution (a mixture in which 4-t-butylpyridine (0.5 mol/dm³), lithium iodide (0.5 mol/dm³), and iodine (0.05 mol/dm³) were mixed into acetonitrile such that the solutes have the respective predetermined concentrations). The upper part of the cell was covered with a mask having an opening of 1 cm², and the conversion efficiency (%) was measured with a solar simulator at AM-1.5G, 100 mW/cm².

Considering that the conversion efficiency in the case of using the aforementioned electrode including the aforementioned dye (B) only is 1, the conversion efficiency in the case of using the electrode including both dyes (A) and (B) was calculated as a relative value. The higher the calculated value, the greater the effect of using several dyes in combination; if the value is smaller than 1, it means that the conversion efficiency has deteriorated by using several dyes in combination. The results are shown in Table 4.

### Examples 2-2 to 2-36 and Comparative Examples 1 to 6:

Conversion efficiency was evaluated according to the dyes and carriers (metal oxide semiconductors) shown in Table 4 according to the same method as in Example 2-1. In each Comparative Example, the dye (B2) indicated in Table 4 was used instead of the dye (A), and the same evaluation was conducted. It should be noted that the dyes listed in (B2) are dyes that are, by nature, classified under dye (B); thus, the Comparative Examples are examples in which two types of dyes selected from (B) are used. To clearly show the difference from the present invention, the same evaluation as that for the Examples--which employed the conversion efficiency in the case of using Dye (B) only as the reference--was conducted for the Comparative Examples.

**[Table 4]**

| | Carrier | (A) Dye | (B) Dye | (B2) Dye | Relative Value |
|---|---|---|---|---|---|
| Example 2-1 | ZnO | A-1 | B-1 | - | 1.36 |
| Example 2-2 | ZnO | A-2 | B-1 | - | 1.54 |
| Example 2-3 | ZnO | A-4 | B-1 | - | 1.16 |
| Example 2-4 | ZnO | A-6 | B-1 | - | 1.14 |
| Example 2-5 | ZnO | A-7 | B-1 | - | 1.41 |
| Example 2-6 | ZnO | A-8 | B-1 | - | 1.99 |
| Example 2-7 | ZnO | A-10 | B-1 | - | 2.52 |
| Example 2-8 | ZnO | A-13 | B-1 | - | 1.16 |
| Example 2-9 | ZnO | A-14 | B-1 | - | 1.25 |
| Example 2-10 | ZnO | A-15 | B-1 | - | 1.20 |
| Example 2-11 | ZnO | A-1 | B-2 | - | 1.09 |
| Example 2-12 | ZnO | A-41 | B-4 | - | 2.20 |
| Example 2-13 | ZnO | A-42 | B-1 | - | 1.43 |
| Example 2-14 | ZnO | A-42 | B-4 | - | 1.35 |
| Example 2-15 | ZnO | A-42 | B-13 | - | 1.16 |
| Example 2-16 | ZnO | A-45 | B-1 | - | 1.46 |
| Example 2-17 | ZnO | A-46 | B-4 | - | 1.62 |
| Example 2-18 | ZnO | A-46 | B-13 | - | 1.16 |
| Example 2-19 | ZnO | A-47 | B-4 | - | 1.09 |
| Example 2-20 | TiO2 | A-1 | B-3 | - | 1.08 |
| Example 2-21 | TiO2 | A-3 | B-3 | - | 1.16 |
| Example 2-22 | TiO2 | A-42 | B-8 | - | 1.29 |
| Example 2-23 | TiO2 | A-43 | B-8 | - | 1.16 |
| Example 2-24 | TiO2 | A-42 | B-3 | - | 1.67 |
| Example 2-25 | TiO2 | A-43 | B-3 | - | 1.64 |
| Example 2-26 | TiO2 | A-43 | B-15 | - | 1.20 |
| Example 2-27 | TiO2 | A-44 | B-4 | - | 1.09 |
| Example 2-28 | TiO2 | A-44 | B-13 | - | 1.22 |
| Example 2-29 | TiO2 | A-48 | B-13 | - | 1.10 |
| Example 2-30 | TiO2 | A-49 | B-13 | - | 1.24 |
| Example 2-31 | TiO2 | A-51 | B-13 | - | 1.45 |
| Example 2-32 | TiO2 | A-54 | B-13 | - | 1.10 |
| Example 2-33 | TiO2 | A-55 | B-13 | - | 1.27 |
| Example 2-34 | TiO2 | A-56 | B-13 | - | 1.12 |
| Example 2-35 | TiO2 | A-57 | B-13 | - | 1.13 |
| Example 2-36 | TiO2 | A-96 | B-13 | - | 1.06 |
| Comparative Example 1 | ZnO | - | B-1 | B2-1 | 0.91 |
| Comparative Example2 | ZnO | - | B-1 | B2-2 | 0.96 |
| Comparative Example3 | ZnO | - | B-1 | B2-3 | 1.02 |
| Comparative Example4 | ZnO | - | B-1 | B2-4 | 1.00 |
| Comparative Example5 | TiO2 | - | B-3 | B2-1 | 0.72 |
| Comparative Example6 | TiO2 | - | B-3 | B2-3 | 1.01 |

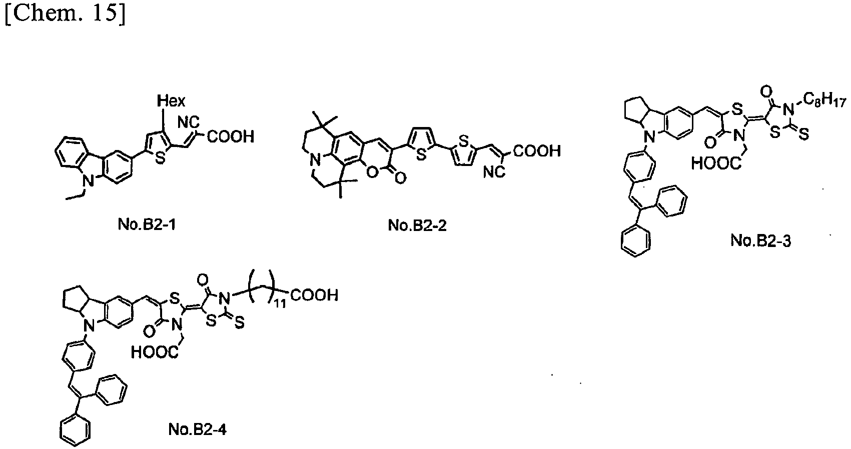

From Examples 2-1 to 2-36, it is clear that the carrier system of the present invention is improved in conversion efficiency by employing the sensitizing dyes (A) and (B) in combination, and it is clear that the effect of combined use cannot be achieved by selecting two types of sensitizing dyes (B), as in Comparative Examples 1 to 6.

### Examples 3-1 to 3-3:

Conversion efficiency was evaluated according to the dyes and carriers (metal oxide semiconductors) shown in Table 5 according to the same method as in Example 2-1, except that the electrolyte solution was changed to a cobalt-based electrolyte solution (a mixture in which a divalent cobalt complex ([Co(bpy)₃(PF₆)₂], 0.22 mol/dm³), a trivalent cobalt complex ([Co(bpy)₃(PF₆)₃], 0.22 mol/dm³), and lithium perchlorate (0.1 mol/dm³) were mixed into acetonitrile such that the solutes have the above respective predetermined concentrations).

**[Table 5]**

| | Carrier | (A) Dye | (B) Dye | Relative Value |
|---|---|---|---|---|
| Example 3-1 | ZnO | A-42 | B-13 | 2.71 |
| Example 3-2 | ZnO | A-42 | B-17 | 1.59 |
| Example 3-3 | TiO2 | A-42 | B-13 | 1.50 |

From Examples 3-1 to 3-3, it is clear that the carrier system of the present invention achieves an excellent effect regardless of the electrolyte solution.

From the above results, it is clear that the use of the carrier system of the present invention as an electrode for a photoelectric conversion device achieves high conversion efficiency, and thus the present carrier system is useful.

### REFERENCE SIGNS LIST

10: Working electrode
11: Conductive substrate
11A: Substrate
11B: Conductive layer
12: Metal oxide semiconductor layer
12A: Dense layer
12B: Porous layer
13: Dye
20: Counter electrode
21: Conductive substrate
22: Conductive layer
30: Electrolyte-containing layer

## Claims

1. A carrier system carrying at least one type of sensitizing dye described in (A) below and at least one type of sensitizing dye described in (B) below:
(A) a sensitizing dye having a π-conjugated group and at least one anchor group, wherein: the π-conjugated group and every one of the anchor group(s) are connected by a spacer having at least one alkylene and having an atomicity of 5 to 20; the spacer is composed of carbon atoms, or at least one carbon atom and at least one type of atom selected from an oxygen atom, a nitrogen atom, a phosphorus atom, a silicon atom, and a sulfur atom, on condition that there are less than three consecutive nitrogen atoms and that atoms of the same type, other than carbon atoms and nitrogen atoms, do not adjoin one another; and the spacer may have a branched chain or a ring structure; and
(B) a sensitizing dye having a π-conjugated group and at least one anchor group, wherein: the π-conjugated group and at least one anchor group are connected by a direct bond or by a spacer having at least one alkylene and having an atomicity of 1 to 4; the spacer is composed of at least one carbon atom, or at least one carbon atom and at least one type of atom selected from an oxygen atom, a nitrogen atom, a phosphorus atom, a silicon atom, and a sulfur atom, on condition that atoms of the same type, other than carbon atoms, do not adjoin one another; and the spacer may have a branched chain or a ring structure.

2. The carrier system according to claim 1, wherein:
the anchor group in the sensitizing dye (A) is a group selected from a carboxylic acid group, a sulfonic acid group, a phosphoric acid group, a phosphonic acid group, or a group represented by -SiR¹R²R³; and
R¹, R², and R³ are each a hydrogen atom, an allyl group, a C₆₋₁₀ aryl group, or a C₁₋₄ alkyl group or alkoxy group.

3. The carrier system according to claim 1 or 2, wherein:
the anchor group in the sensitizing dye (B) is a group selected from a carboxylic acid group, a sulfonic acid group, a phosphoric acid group, a phosphonic acid group, or a group represented by -SiR¹R²R³; and
R¹, R², and R³ are each a hydrogen atom, an allyl group, a C₆₋₁₀ aryl group, or a C₁₋₄ alkyl group or alkoxy group.

4. The carrier system according to any one of claims 1 to 3, wherein the π-conjugated group in the sensitizing dye (A) is represented by a partial structural formula (1) shown below: 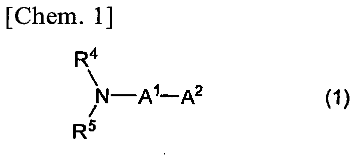 (in the formula, A¹ is an aromatic hydrocarbon ring group that may be substituted or an aromatic hetero ring group that may be substituted, A² is a direct bond or a group obtained by connecting one to nine groups selected from groups represented by formulas (A2-1) to (A2-19) shown below, R⁴ and R⁵ each represent a hydrogen atom or a hydrocarbon group that may be substituted, R⁴ and R⁵ may be connected together to form a ring, and R⁴ and R⁵ may each independently connect with A¹ to form a ring); 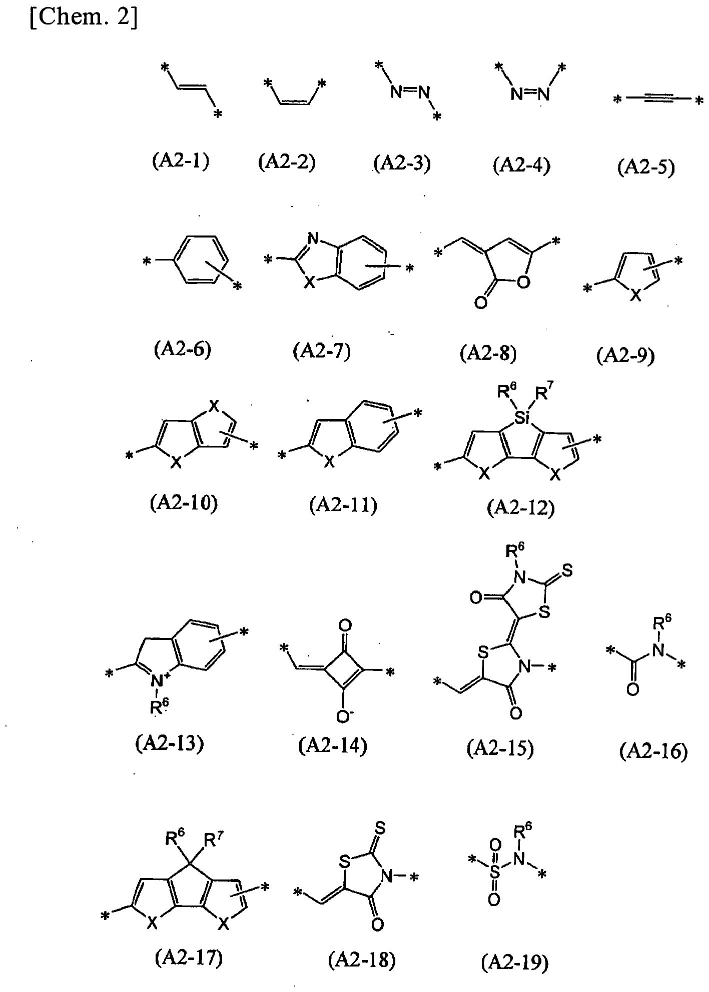 (in the formula, X represents S, O, or NR, R represents a hydrogen atom or a hydrocarbon group that may be substituted, a hydrogen atom in this group may be substituted by a fluorine atom, a chlorine atom, a bromine atom, an iodine atom, a cyano group, a nitro group, an -OR⁶ group, an -SR⁶ group, an -NR⁶R⁷ group, or an aliphatic hydrocarbon group that may be substituted, and R⁶ and R⁷ each represent a hydrogen atom or a hydrocarbon group that may be substituted).

5. The carrier system according to claim 4, wherein a partial structure (2) shown below in the aforementioned partial structural formula (1) is one of partial structures (2-1) to (2-14) shown below: 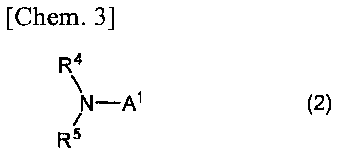 (in the formula, A¹, R⁴, and R⁵ are respectively the same as A¹, R⁴, and R⁵ in the aforementioned partial structural formula (1)); 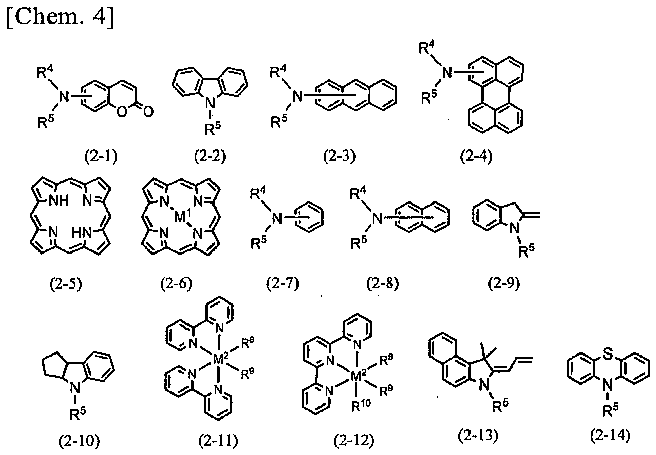 (in the formula, R⁴ and R⁵ are respectively the same as R⁴ and R⁵ in the aforementioned partial structural formula (2), R⁸, R⁹, and R¹⁰ each represent a known ligand that coordinates with M², M¹ and M² each represent a metal element, a hydrogen atom in the formula may be substituted by a fluorine atom, a chlorine atom, an iodine atom, a cyano group, a nitro group, an -OR⁶ group, an -SR⁶ group, or an aliphatic hydrocarbon group that may be substituted, and R⁶ represents a hydrogen atom or a hydrocarbon group that may be substituted).

6. A photoelectric conversion device comprising an electrode including the carrier system according to any one of claims 1 to 5.

7. A carrier system production method comprising fixing at least one type of sensitizing dye described in (A) below and at least one type of sensitizing dye described in (B) below:
(A) a sensitizing dye having a π-conjugated group and at least one anchor group, wherein: the π-conjugated group and every one of the anchor group(s) are connected by a spacer having at least one alkylene and having an atomicity of 5 to 20; the spacer is composed of carbon atoms, or at least one carbon atom and at least one type of atom selected from an oxygen atom, a nitrogen atom, a phosphorus atom, a silicon atom, and a sulfur atom, on condition that there are less than three consecutive nitrogen atoms and that atoms of the same type, other than carbon atoms and nitrogen atoms, do not adjoin one another; and the spacer may have a branched chain or a ring structure; and
(B) a sensitizing dye having a π-conjugated group and at least one anchor group, wherein: the π-conjugated group and at least one anchor group are connected by a direct bond or by a spacer having at least one alkylene and having an atomicity of 1 to 4; the spacer is composed of at least one carbon atom, or at least one carbon atom and at least one type of atom selected from an oxygen atom, a nitrogen atom, a phosphorus atom, a silicon atom, and a sulfur atom, on condition that atoms of the same type, other than carbon atoms, do not adjoin one another; and the spacer may have a branched chain or a ring structure.

8. A compound comprising a π-conjugated group and at least one anchor group, wherein:
the π-conjugated group is represented by a partial structural formula (1') shown below;
the π-conjugated group and every one of the anchor group(s) are connected by a spacer having at least one alkylene and having an atomicity of 5 to 20;
the spacer is composed of carbon atoms, or at least one carbon atom and at least one type of atom selected from an oxygen atom, a nitrogen atom, a phosphorus atom, and a sulfur atom, on condition that atoms of the same type, other than carbon atoms, do not adjoin one another; and
the spacer may have a branched chain or a ring structure; 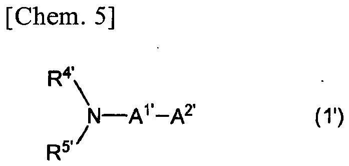 (in the formula, A^{1'} is an aromatic hydrocarbon ring group that may be substituted or an aromatic hetero ring group that may be substituted, A^{2'} is a direct bond or a group obtained by connecting one to nine groups selected from groups represented by formulas (A2'-1) to (A2'-19) shown below, R^{4'} and R^{5'} each represent a hydrogen atom or a hydrocarbon group that may be substituted, R^{4'} and R^{5'} may be connected together to form a ring, and R^{4'} and R^{5'} may each independently connect with A^{1'} to form a ring); 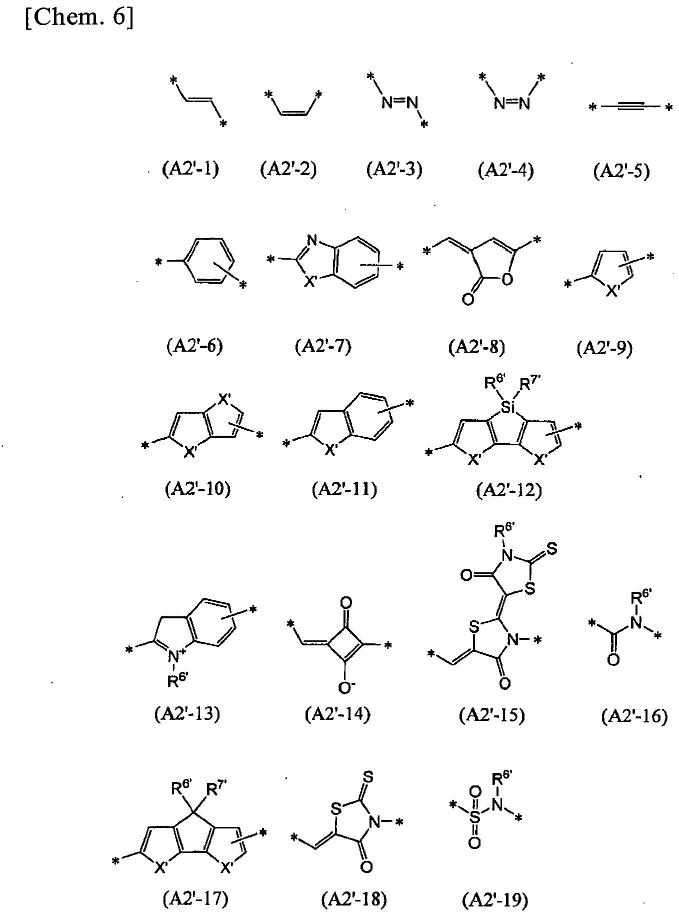 (in the formula, X' represents S, O, or NR', R' represents a hydrogen atom or a hydrocarbon group that may be substituted, a hydrogen atom in this group may be substituted by a fluorine atom, a chlorine atom, a bromine atom, an iodine atom, a cyano group, a nitro group, an -OR^{6'} group, an -SR^{6'} group, an -NR^{6'}R^{7'} group, or an aliphatic hydrocarbon group that may be substituted, and R^{6'} and R^{7'} each represent a hydrogen atom or a hydrocarbon group that may be substituted).

9. The compound according to claim 8, wherein a partial structure (2') shown below in the aforementioned partial structural formula (1') is one of partial structures (2'-1) to (2'-14) shown below: 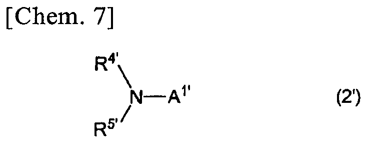 (in the formula, A^{1'}, R^{4'}, and R^{5'} are respectively the same as A^{1'}, R^{4'}, and R^{5'} in the aforementioned partial structural formula (1')); 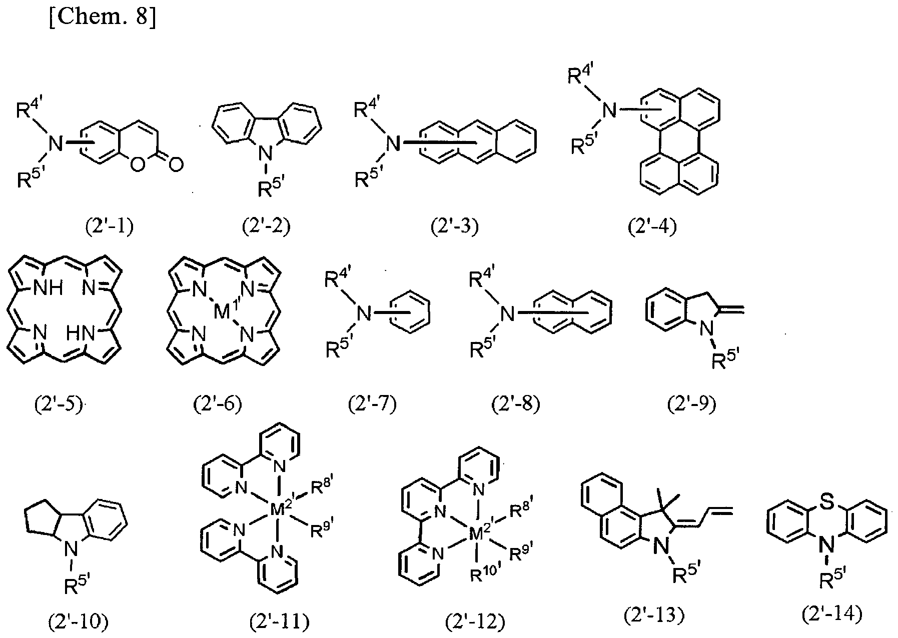 (in the formula, R^{4'} and R^{5'} are respectively the same as R^{4'} and R^{5'} in the aforementioned partial structural formula (2'), R^{8'}, R^{9'}, and R^{10'} each represent a known ligand that coordinates with M^{2'}, M^{1'} and M^{2'} each represent a metal element, a hydrogen atom in the formula may be substituted by a fluorine atom, a chlorine atom, an iodine atom, a cyano group, a nitro group, an -OR^{6'} group, an -SR^{6'} group, or an aliphatic hydrocarbon group that may be substituted, and R^{6'} represents a hydrogen atom or a hydrocarbon group that may be substituted).
